(19) Europäisches Patentamt / European Patent Office / Office européen des brevets

(11) **EP 4 243 054 A1**

(12) **EUROPEAN PATENT APPLICATION**
published in accordance with Art. 153(4) EPC

(43) Date of publication:
**13.09.2023 Bulletin 2023/37**

(21) Application number: **21889009.3**

(22) Date of filing: **18.10.2021**

(51) International Patent Classification (IPC):
**H01L 21/205** (2006.01)    **C23C 16/458** (2006.01)
**C23C 16/46** (2006.01)

(52) Cooperative Patent Classification (CPC):
**C23C 16/458; C23C 16/46; C30B 25/10;
C30B 25/12; C30B 29/36; H01L 21/67;**
H01L 21/02532; H01L 21/02579; H01L 21/0262

(86) International application number:
**PCT/JP2021/038355**

(87) International publication number:
**WO 2022/097456 (12.05.2022 Gazette 2022/19)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.11.2020   JP 2020186828**

(71) Applicant: **NuFlare Technology, Inc.
Yokohama-shi, Kanagawa 235-8522 (JP)**

(72) Inventors:
• **DAIGO, Yoshiaki
  Yokohama-shi, Kanagawa 235-8522 (JP)**
• **MORIYAMA, Yoshikazu
  Yokohama-shi, Kanagawa 235-8522 (JP)**

(74) Representative: **Hoffmann Eitle
Patent- und Rechtsanwälte PartmbB
Arabellastraße 30
81925 München (DE)**

(54) **VAPOR PHASE GROWTH APPARATUS**

(57)    A vapor phase growth apparatus according to an embodiment includes: a reactor; a holder provided in the reactor to place a substrate thereon; a first heater provided in the reactor and located below the holder; and a second heater provided in the reactor and located above the holder, wherein the holder includes an inner region, an annular outer region surrounding the inner region and surrounding the substrate when the substrate is placed, and a support portion provided on the inner region, capable of supporting a bottom surface of the substrate, having an annular shape, and having an arc portion, a distance between an outer peripheral edge of the arc portion and an inner peripheral edge of the outer region is equal to or less than 6 mm, a width of the support portion is equal to or more than 3 mm, and when the substrate is placed on the holder so that a center of the substrate and a center of the holder are aligned, assuming that a radius of the substrate is R1, a radius of the outer peripheral edge of the arc portion is R4, and a distance between an outer peripheral edge of the substrate and an inner peripheral edge of the outer region facing the arc portion is D1, following Expression 1 is satisfied.

$$R1 - D1 > R4 \ldots \text{(Expression 1)}$$

FIG. 3

(a)

(b)

**Description**

TECHNICAL FIELD

The present invention relates to a vapor phase growth apparatus that forms a film on the surface of a substrate by supplying a gas to the substrate surface.

BACKGROUND ART

As a method of forming a high-quality semiconductor film, there is an epitaxial growth technique for forming a single crystal film on the surface of a substrate by vapor phase growth. In a vapor phase growth apparatus using the epitaxial growth technique, a substrate is placed on a holder in a reactor held at atmospheric pressure or reduced pressure.
Then, while heating the substrate, a process gas containing the raw material of a film is supplied to the reactor through a buffer chamber above the reactor. A thermal reaction of the process gas occurs on the surface of the substrate, so that an epitaxial single crystal film is formed on the substrate surface.
The properties of the epitaxial single crystal film formed on the substrate surface depend on the temperature of the substrate. Therefore, in order to improve the uniformity of the properties of the film formed on the substrate, it is desired to improve the uniformity of the temperature of the substrate surface. In particular, in the case of a film formed at a high temperature such as a silicon carbide film, it becomes difficult to maintain the uniformity of the temperature of the substrate surface.
Patent Document 1 describes a vapor phase growth apparatus in which a support portion is provided in a susceptor for supporting a substrate in order to uniformly heat the substrate.

CITATION LIST

PATENT DOCUMENT

Patent Document 1: JP 2018-37537 A

SUMMARY OF THE INVENTION

PROBLEM TO BE SOLVED BY THE INVENTION

A problem to be solved by the invention is to provide a vapor phase growth apparatus capable of improving the uniformity of the temperature of a substrate.

MEANS FOR SOLVING PROBLEM

A vapor phase growth apparatus according to an aspect of the invention includes: a reactor; a holder provided in the reactor to place a substrate thereon; a first heater provided in the reactor and located below the holder; and a second heater provided in the reactor and located above the holder. The holder includes an inner region, an annular outer region surrounding the inner region and surrounding the substrate when the substrate is placed, and a support portion provided on the inner region, capable of supporting a bottom surface of the substrate, having an annular shape, and having an arc portion. A distance between an outer peripheral edge of the arc portion and an inner peripheral edge of the outer region is equal to or less than 6 mm, and a width of the support portion is equal to or more than 3 mm. When the substrate is placed on the holder so that a center of the substrate and a center of the holder are aligned, assuming that a radius of the substrate is R1, a radius of the outer peripheral edge of the arc portion is R4, and a distance between an outer peripheral edge of the substrate and an inner peripheral edge of the outer region facing the arc portion is D1, the following Expression 1 is satisfied.

$$R1 - D1 > R4 \ ...(\text{Expression 1})$$

EFFECT OF THE INVENTION

According to the invention, it is possible to realize a vapor phase growth apparatus capable of improving the uniformity of the temperature of the substrate.

BRIEF DESCRIPTION OF DRAWINGS

Fig. 1 is a schematic cross-sectional view of a vapor phase growth apparatus according to a first embodiment;
Fig. 2 is a schematic diagram of a holder according to the first embodiment;
Fig. 3 is a schematic diagram of the holder according to the first embodiment;
Fig. 4 is an enlarged schematic cross-sectional view of the holder according to the first embodiment;
Fig. 5 is a schematic diagram of a holder of a first comparative example;
Fig. 6 is a schematic diagram of the holder of the first comparative example;
Fig. 7 is an explanatory diagram of a first problem of the holder of the first comparative example;
Fig. 8 is an explanatory diagram of a second problem of the holder of the first comparative example;
Fig. 9 is an explanatory diagram of the function and effect of the first embodiment;
Fig. 10 is an explanatory diagram of the function and effect of the first embodiment;
Fig. 11 is an explanatory diagram of the function and effect of the first embodiment;
Fig. 12 is an explanatory diagram of the function and effect of the first embodiment;
Fig. 13 is a schematic diagram of a holder of a second comparative example;
Fig. 14 is an enlarged schematic cross-sectional view of the holder of the second comparative example;
Fig. 15 is an enlarged schematic cross-sectional view of the holder according to the first embodiment;
Fig. 16 is a schematic diagram of a holder according to a second embodiment;
Fig. 17 is a schematic diagram of a holder according to a third embodiment;
Fig. 18 is a schematic diagram of the holder according to the third embodiment;
Fig. 19 is an explanatory diagram of the function and effect of the third embodiment;
Fig. 20 is a schematic diagram of a holder according to a fourth embodiment;
Fig. 21 is an enlarged schematic cross-sectional view of the holder according to the fourth embodiment;
Fig. 22 is an enlarged schematic cross-sectional view of the holder according to the fourth embodiment;
Fig. 23 is a schematic diagram of a holder according to a fifth embodiment;
Fig. 24 is an enlarged schematic cross-sectional view of the holder according to the fifth embodiment;
Fig. 25 is a schematic diagram of a holder according to a sixth embodiment;
Fig. 26 is a schematic diagram of a holder according to a seventh embodiment;
Fig. 27 is a schematic diagram of the holder according to the seventh embodiment;
Fig. 28 is a schematic diagram of a holder according to an eighth embodiment;
Fig. 29 is an explanatory diagram of the function and effect of the eighth embodiment; and
Fig. 30 is an explanatory diagram of the function and effect of the eighth embodiment.

EMBODIMENT(S) FOR CARRYING OUT THE INVENTION

Hereinafter, embodiments of the invention will be described with reference to the diagrams.

In this specification, the same or similar members may be denoted by the same reference numerals.

In this specification, the direction of gravity in a state in which a vapor phase growth apparatus is installed so that a film can be formed is defined as "down", and the opposite direction is defined as "up". Therefore, "lower" means a position in the direction of gravity with respect to the reference, and "downward" means the direction of gravity with respect to the reference. Then, "upper" means a position in a direction opposite to the direction of gravity with respect to the reference, and "upward" means a direction opposite to the direction of gravity with respect to the reference. In addition, the "vertical direction" is the direction of gravity.

In addition, in this specification, "process gas" is a general term for gases used for forming a film, and is a concept including, for example, a source gas, an assist gas, a dopant gas, a carrier gas, and a mixed gas thereof.

(First Embodiment)

A vapor phase growth apparatus according to a first embodiment includes: a reactor; a holder provided in the reactor to place a substrate thereon; a first heater provided in the reactor and located below the holder; and a second heater provided in the reactor and located above the holder, wherein the holder includes an inner region, an annular outer region surrounding the inner region and surrounding the substrate when the substrate is placed, and a support portion provided on the inner region, capable of supporting a bottom surface of the substrate, having an annular shape, and having an arc portion, a distance between an outer peripheral edge of the arc portion and an inner peripheral edge of the outer region is equal to or less than 6 mm, a width of the support portion is equal to or more than 3 mm, and when the substrate is placed on the holder so that a center of the substrate and a center of the holder are aligned, assuming that a radius of the substrate is R1, a radius of the outer peripheral edge of the arc portion is R4, and a distance between an outer peripheral edge of the substrate and an inner peripheral edge of the outer region facing the arc portion is D1, the following Expression 1 is satisfied.

$$R1 - D1 > R4...(Expression\ 1)$$

In addition, assuming that a radius of a film quality guaranteed region of the substrate is R2 and a radius of an inner peripheral edge of the arc portion is R3, the holder satisfies the following Expressions 2 and 3.

$$R2 - D1 > R3...(Expression\ 2)$$

$$R2 + D1 < R4...(Expression\ 3)$$

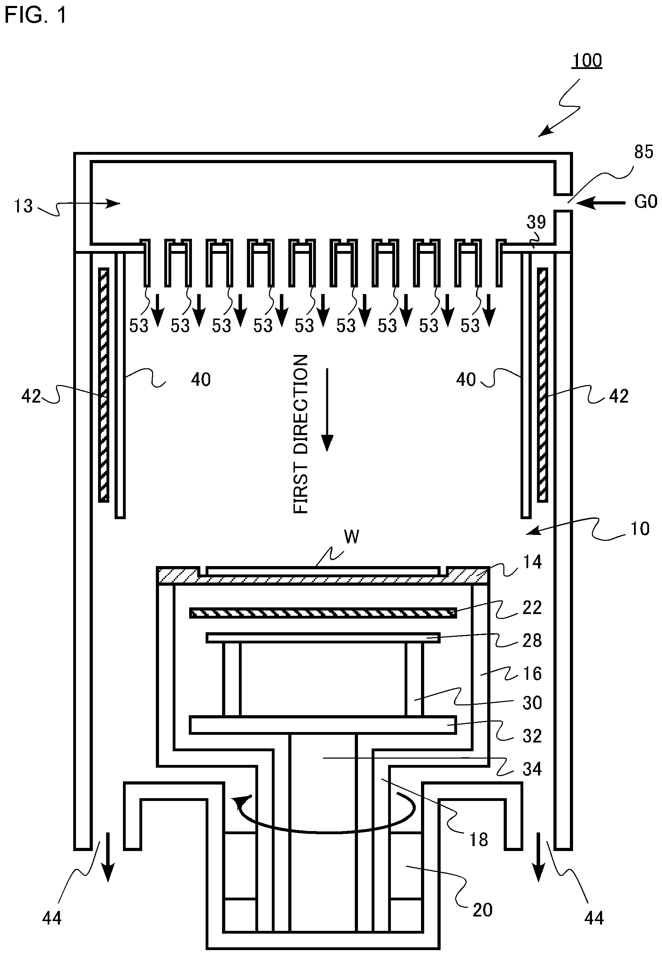

Fig. 1 is a schematic cross-sectional view of the vapor phase growth apparatus according to the first embodiment. A vapor phase growth apparatus 100 according to the first embodiment is, for example, a single wafer type epitaxial growth apparatus for epitaxially growing a single crystal silicon carbide film on a single crystal silicon carbide substrate.

The vapor phase growth apparatus 100 according to the first embodiment includes a reactor 10 and a buffer chamber 13. The reactor 10 includes a susceptor 14 (holder), a rotating body 16, a rotating shaft 18, a rotation driving mechanism 20, a first heater 22, a reflector 28, a support column 30, a fixing table 32, a fixing shaft 34, a hood 40, a second heater 42, a gas discharge port 44, and a gas conduit 53. The buffer chamber 13 includes a partition plate 39 and a gas supply port 85.

The reactor 10 is formed of, for example, stainless steel. The reactor 10 has a cylindrical wall. In the reactor 10, a silicon carbide film is formed on a wafer W. The wafer W is an example of a substrate. The wafer W is, for example, a semiconductor wafer. The wafer W is, for example, a single crystal silicon carbide wafer.

The susceptor 14 is provided in the reactor 10. The wafer W can be placed on the susceptor 14. The susceptor 14 is an example of a holder.

The susceptor 14 is formed of a highly heat-resistant material such as silicon carbide, graphite, or graphite coated with silicon carbide, tantalum carbide, pyrolytic graphite, or the like.

The susceptor 14 is fixed to the upper part of the rotating body 16. The rotating body 16 is fixed to the rotating shaft 18. The susceptor 14 is indirectly fixed to the rotating shaft 18.

The rotating shaft 18 can be rotated by the rotation driving mechanism 20. By rotating the rotating shaft 18, it is possible to rotate the susceptor 14. By rotating the susceptor 14, it is possible to rotate the wafer W placed on the susceptor 14.

With the rotation driving mechanism 20, for example, the wafer W can be rotated at a rotation speed of 300 rpm or more and 3000 rpm or less. The rotation driving mechanism 20 is formed by, for example, a motor and a bearing.

The first heater 22 is provided below the susceptor 14. The first heater 22 is provided in the rotating body 16. The first heater 22 heats the wafer W held by the susceptor 14 from below. The first heater 22 is, for example, a resistor heater. The first heater 22 has, for example, a disc shape with a comb-shaped pattern.

The reflector 28 is provided below the first heater 22. The first heater 22 is provided between the reflector 28 and the susceptor 14.

The reflector 28 reflects the heat radiated downward from the first heater 22 to improve the heating efficiency of the wafer W. In addition, the reflector 28 prevents the members below the reflector 28 from being heated. The reflector 28 has, for example, a disk shape. The reflector 28 is formed of a highly heat-resistant material such as silicon carbide, graphite, or graphite coated with silicon carbide, tantalum carbide, pyrolytic graphite, or the like.

The reflector 28 is fixed to the fixing table 32 by, for example, a plurality of support columns 30. The fixing table 32 is supported by, for example, the fixing shaft 34.

In order to attach and detach the susceptor 14 to and from the rotating body 16, a push up pin (not shown) is provided in the rotating body 16. The push up pin penetrates, for example, the reflector 28 and the first heater 22.

The second heater 42 is provided between the hood 40 and the inner wall of the reactor 10. The second heater 42 is located above the susceptor 14.

The second heater 42 heats the wafer W held by the susceptor 14 from above. By heating the wafer W with the second heater 42 in addition to the first heater 22, it is possible to heat the wafer W to a temperature required for the growth of the silicon carbide film, for example, a temperature of 1500°C or higher. The second heater 42 is, for example, a resistor heater.

The hood 40 has, for example, a cylindrical shape. The hood 40 has a function of preventing a first process gas G1 or a second process gas G2 from coming into contact with the second heater 42. The hood 40 is formed of a highly heat-resistant material such as graphite or graphite coated with silicon carbide.

The gas discharge port 44 is provided at the bottom of the reactor 10. The gas discharge port 44 discharges a surplus by-product after the source gas reacts on the surface of the wafer W and a surplus process gas to the outside of the reactor 10. The gas discharge port 44 is connected to, for example, a vacuum pump (not shown).

In addition, a susceptor inlet/outlet and a gate valve (not shown) are provided in the reactor 10. The susceptor 14 on which the wafer W is placed can be loaded into the reactor 10 or unloaded to the outside of the reactor 10 by the susceptor inlet/outlet and the gate valve.

The buffer chamber 13 is provided above the reactor 10. The gas supply port 85 for introducing a process gas G0 is provided in the buffer chamber 13. The process gas G0 introduced from the gas supply port 85 is filled in the buffer chamber 13.

The process gas G0 is, for example, a mixed gas containing a source gas of silicon (Si), a source gas of carbon (C), a dopant gas of n-type impurities, a dopant gas of p-type impurities, an assist gas for suppressing silicon clustering, and a carrier gas. The silicon source gas is, for example, silane ($SiH_4$). The carbon source gas is, for example, propane ($C_3H_8$). The dopant gas of n-type impurities is, for example, a nitrogen gas. The p-type impurity dopant gas is, for example, trimethylaluminum (TMA). The assist gas is, for example, hydrogen chloride (HCl). The carrier gas is, for example, argon gas or hydrogen gas.

A plurality of gas conduits 53 are provided between the buffer chamber 13 and the reactor 10. The gas conduit 53 extends from the buffer chamber 13 in the first direction toward the reactor 10. The plurality of gas conduits 53 supply the process gas G0 from the buffer chamber 13 to the reactor 10.

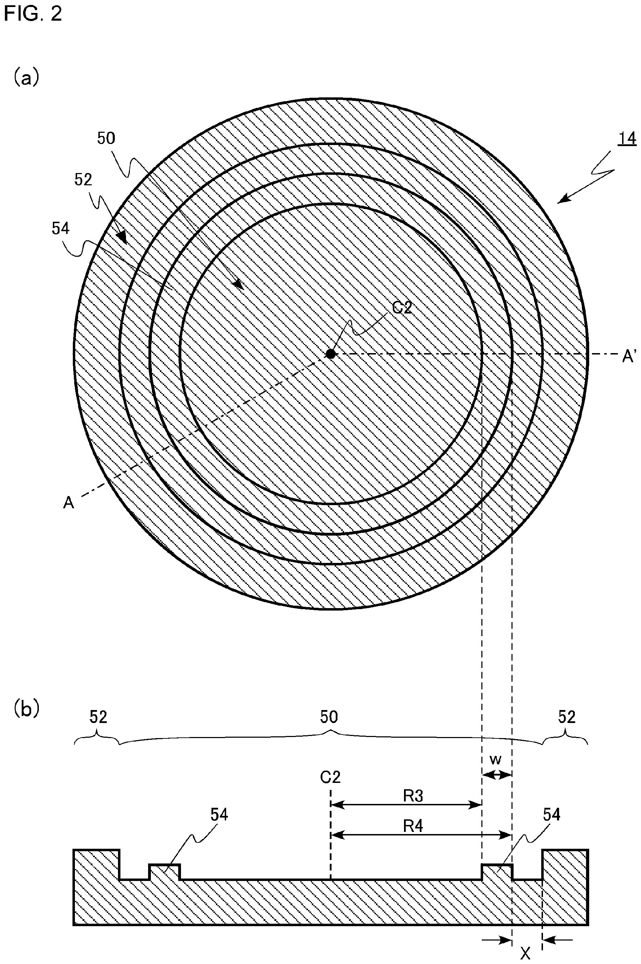

Fig. 2 is a schematic diagram of the holder according to the first embodiment. Fig. 2(a) is a top view, and Fig. 2(b) is a cross-sectional view taken along the line AA' of Fig. 2(a).

The susceptor 14 has a center C2 (second center). The center C2 is, for example, the center position of a circle forming the outer edge of the susceptor 14.

The susceptor 14 includes an inner region 50 and an outer region 52. The outer region 52 surrounds the inner region 50. The outer region 52 surrounds the wafer W when the wafer W is placed on the susceptor 14.

The inner region 50 has a disc shape. The outer region 52 has an annular shape.

An annular support portion 54 having an arc portion is provided on the inner region 50. Fig. 2 shows a case where the support portion 54 has a circular shape. That is, Fig. 2 shows a case where the entire support portion 54 is an arc portion. The annular support portion 54 is provided apart from the outer region 52.

The support portion 54 can support the bottom surface of the wafer W when the wafer W is placed on the susceptor 14.

The radius of the inner peripheral edge of the support portion 54 is R3. The radius of the outer peripheral edge of the support portion 54 is R4.

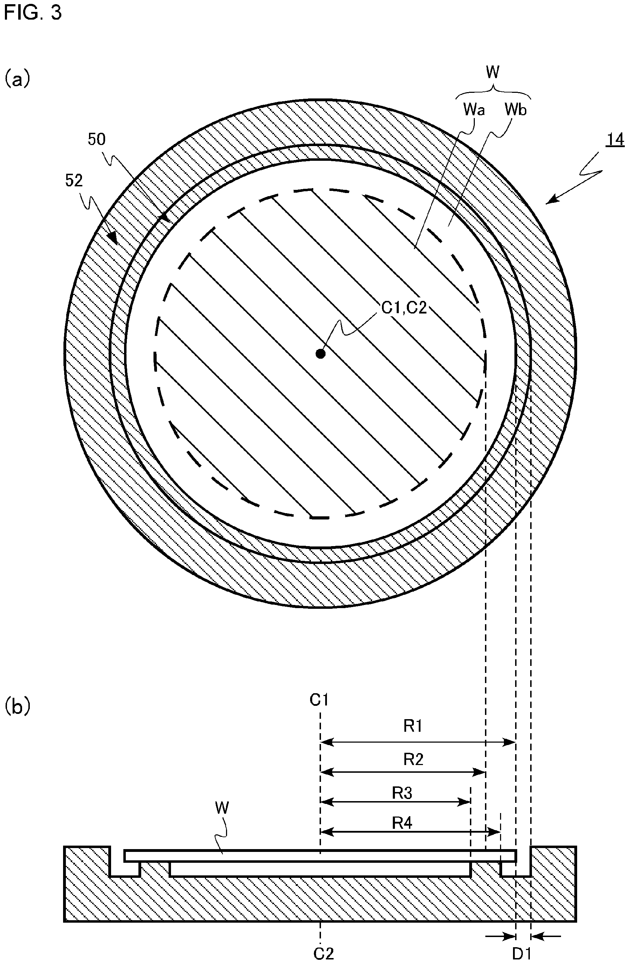

Fig. 3 is a schematic diagram of the holder according to the first embodiment. Fig. 3(a) is a top view corresponding to Fig. 2(a), and Fig. 3(b) is a cross-sectional view corresponding to Fig. 2(b).

Fig. 3 is a diagram showing a state in which the wafer W is placed on the susceptor 14. Fig. 3 shows a case where the center C1 (first center) of the wafer W and the center C2 (second center) of the susceptor 14 are aligned.

The wafer W has a film quality guaranteed region Wa and a film quality non-guaranteed region Wb. In this specification, film quality is, for example, film thickness, carrier concentration, surface roughness, defect density, carrier lifetime, and the like. In addition, the film quality guaranteed region Wa is, for example, a region where it is guaranteed that film thickness, carrier concentration, surface roughness, defect density, carrier lifetime, and the like satisfy specific specifications on the wafer W. Normally, the film quality guaranteed region Wa is provided on the central side on the wafer W. The film quality non-guaranteed region Wb is, for example, a region where it is not guaranteed that film thickness, carrier concentration, surface roughness, defect density, carrier lifetime, and the like satisfy specific specifications on the wafer. Normally, the film quality non-guaranteed region Wb is provided on the outer peripheral side on the wafer. In addition, the film quality guaranteed region Wa may be determined for each film quality, such as film thickness, carrier concentration, surface roughness, defect density, and carrier lifetime. Also in this specification, the film quality guaranteed region Wa does not need to be the same for all film qualities, and it is sufficient if the film quality guaranteed region Wa is determined for at least one film quality.

It is assumed that the radius of the wafer W be R1. It is assumed that the radius of the film quality guaranteed region Wa is R2. The difference between R1 and R2 is, for example, equal to or more than 3 mm and equal to or less than 6 mm.

A distance (D1 in Fig. 3(b)) between the outer peripheral edge of the wafer W and the inner peripheral edge of the outer region 52 is, for example, equal to or more than 0.5 mm and equal to or less than 3 mm.

The radius R3 of the inner peripheral edge of the support portion 54 is equal to or more than 85% of the radius R1 of the wafer W, for example.

Regarding the radius R1 of the wafer W, the radius R2 of the film quality guaranteed region Wa of the wafer W, the radius R3 of the inner peripheral edge of the support portion 54, the radius R4 of the outer peripheral edge of the support portion 54, and the distance D1, the following Expressions 1, 2, and 3 are satisfied.

$$R1 - D1 > R4...(Expression\ 1)$$

$$R2 - D1 > R3...(Expression\ 2)$$

$$R2 + D1 < R4...(Expression\ 3)$$

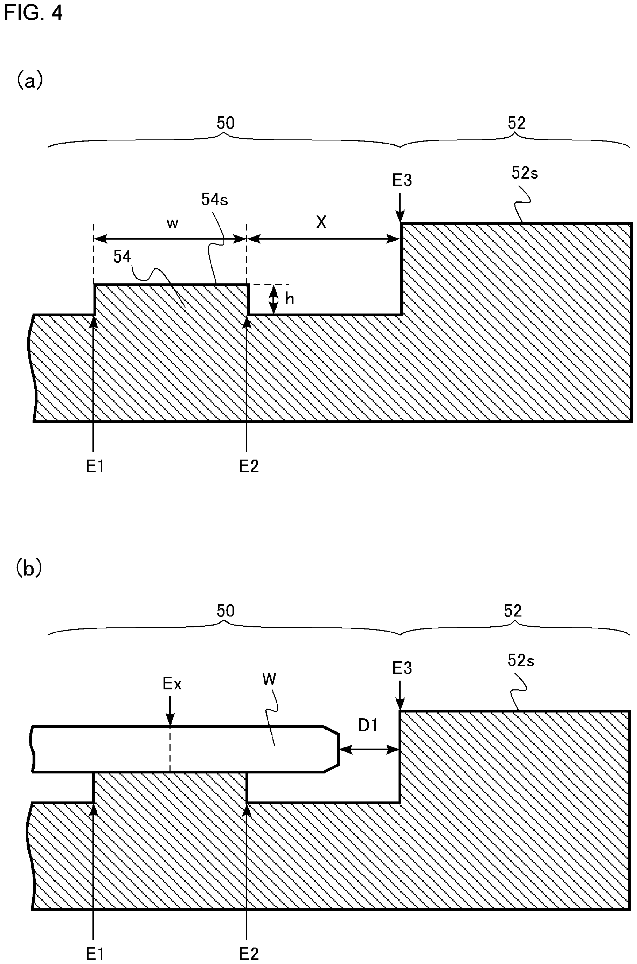

Fig. 4 is an enlarged schematic cross-sectional view of the holder according to the first embodiment. Fig.

4 is a cross-sectional view of a part of the inner region 50 including the support portion 54 and the outer region 52. Fig. 4(a) shows a state in which the wafer W is not placed, and Fig. 4B shows a state in which the wafer W is placed in a state in which the center C1 (first center) of the wafer W and the center C2 (second center) of the susceptor 14 are aligned.

The position of a top surface 52s of the outer region 52 is higher than the position of a top surface 54s of the support portion 54. When the wafer W is placed on the susceptor 14, the position of a top surface 52s of the outer region 52 is higher than the position of the surface of the wafer W, for example.

The inner peripheral edge (E3 in Fig. 4(a)) of the outer region 52 and the support portion 54 are spaced apart from each other. A distance (X in Fig. 4(a)) between the outer peripheral edge (E2 in Fig. 4(a)) of the support portion 54 and the inner peripheral edge E3 of the outer region 52 is, for example, equal to or more than 2 mm and equal to or less than 6 mm.

The width (w in Fig. 4(a)) of the support portion 54 is, for example, equal to or more than 3 mm and equal to or less than 10 mm. The width w of the support portion 54 is equal to the difference between the radius R4 of the outer peripheral edge E2 of the support portion 54 and the radius R3 of the inner peripheral edge (E1 in Fig. 4(a)) of the support portion 54.

The height (h in Fig. 4(a)) of the support portion 54 is, for example, equal to or more than 0.5 mm and equal to or less than 3 mm.

The height h of the support portion 54 is, for example, equal to or smaller than the width w of the support portion 54.

As shown in Fig. 4(b), the edge (Ex in Fig. 4(b)) of the film quality guaranteed region Wa is located on the support portion 54. In other words, the edge Ex of the film quality guaranteed region Wa is located between the inner peripheral edge E1 of the support portion 54 and the outer peripheral edge E2 of the support portion 54.

When forming a silicon carbide film on the wafer W using the vapor phase growth apparatus 100, first, the susceptor 14 on which wafer W is placed is introduced into the reactor 10. The susceptor 14 is placed on the rotating body 16.

The wafer W is heated by using the first heater 22 and the second heater 42. For example, the wafer W is heated to 1500°C or higher. The process gas G0 is supplied from the buffer chamber 13 to the reactor 10 through the plurality of gas conduits 53.

By using the rotation driving mechanism 20, the rotating body 16 is rotated to rotate the susceptor 14.

The wafer W placed on the susceptor 14 rotates together with the susceptor 14.

A silicon carbide film is formed on the surface of the rotating wafer W.

Next, the function and effect of the vapor phase growth apparatus according to the first embodiment will be described.

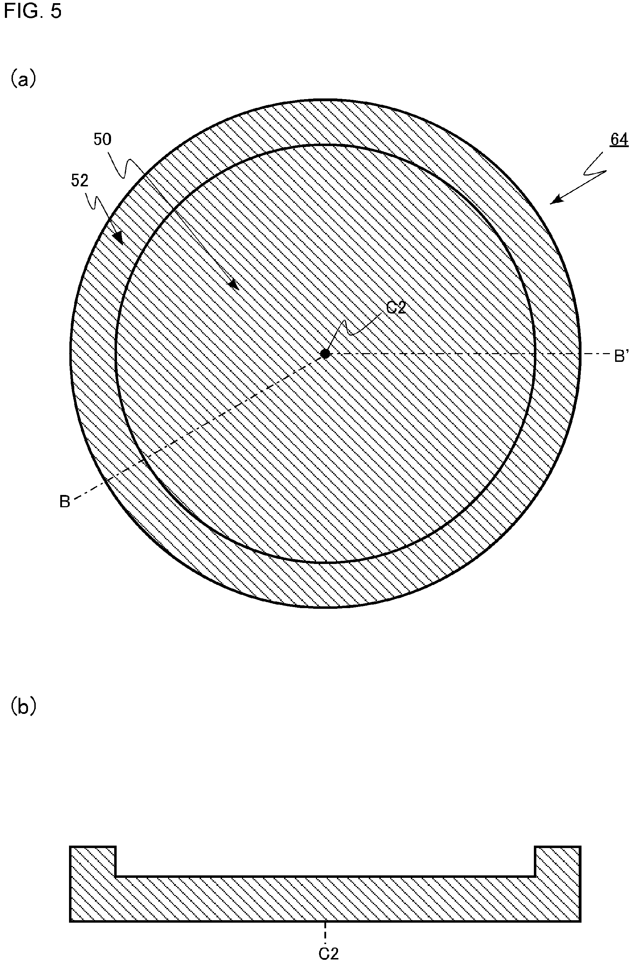

Fig. 5 is a schematic diagram of a holder of a first comparative example. Fig. 5(a) is a top view, and Fig. 5(b) is a cross-sectional view taken along the line BB' of Fig. 5(a).

A susceptor 64 of the first comparative example has a center C2. The susceptor 64 includes an inner region 50 and an outer region 52. The outer region 52 surrounds the inner region 50. The outer region 52 surrounds the wafer W when the wafer W is placed on the susceptor 14.

The susceptor 64 of the first comparative example is different from the susceptor 14 according to the first embodiment in that the support portion 54 is not provided.

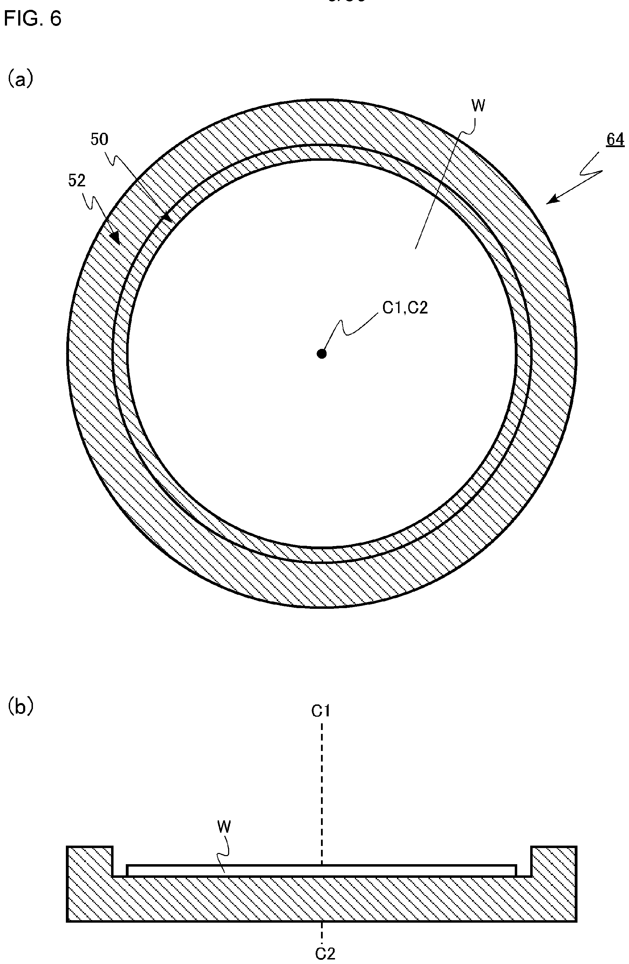

Fig. 6 is a schematic diagram of the holder of the first comparative example. Fig. 6(a) is a top view corresponding to Fig. 5(a), and Fig. 6(b) is a cross-sectional view corresponding to Fig. 5(b).

Fig. 6 is a diagram showing a state in which the wafer W is placed on the susceptor 64. Fig. 6 shows a case where the center C1 of the wafer W and the center C2 of the susceptor 64 are aligned.

As shown in Fig. 6(b), the entire back surface of the wafer W is in contact with the surface of the susceptor 64.

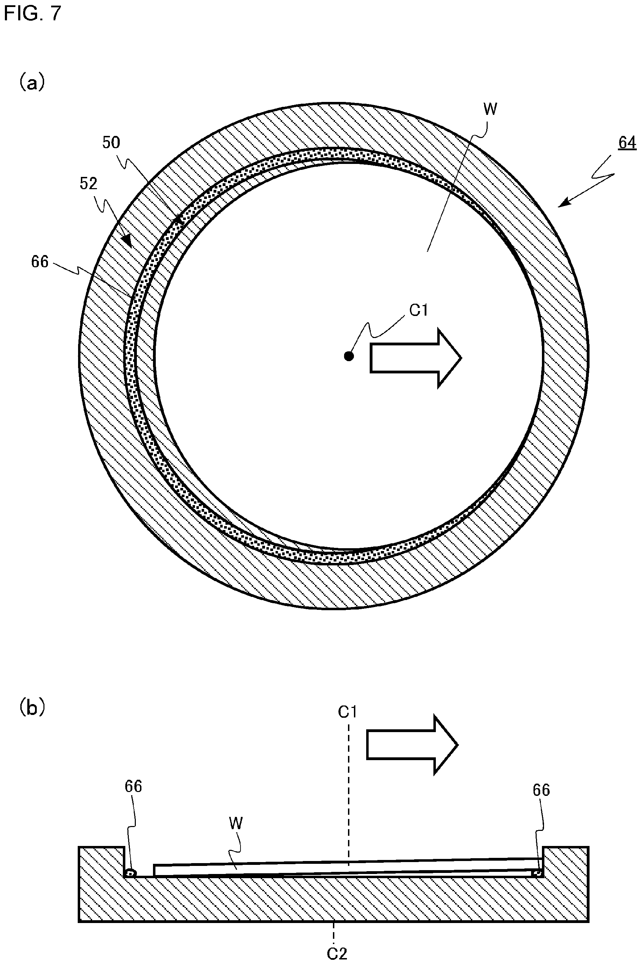

Fig. 7 is an explanatory diagram of a first problem of the holder of the first comparative example. Fig. 7 is a schematic diagram of the holder of the first comparative example. Fig. 7(a) is a top view corresponding to Fig. 6(a), and Fig. 6(b) is a cross-sectional view corresponding to Fig. 6(b).

Fig. 7 shows a case where the center C1 of the wafer W and the center C2 of the susceptor 64 are not aligned. In other words, Fig. 7 shows a case where the wafer W deviates from the center C2 of the susceptor 64.

When forming a silicon carbide film on the surface of the wafer W, a by-product 66 may be formed in a region of the inner region 50 of the susceptor 64 that is not covered with the wafer W. The by-product 66 contains, for example, silicon carbide.

For example, as shown in Fig. 7, when the wafer W rides on the by-product 66, a part of the back surface of the wafer W becomes away from the surface of the inner region 50 of the susceptor 64. Since a part of the back surface of the wafer W is away from the surface of the inner region 50 of the susceptor 64, a variation in the temperature of the surface of the wafer W increases. Therefore, the uniformity of the film quality of the silicon carbide film is degraded.

In addition, when the wafer W rides on the by-product 66, the by-product 66 adheres to the back surface of the wafer W, for example. When the by-product 66 adheres to the back surface of the wafer W, the flatness of the back surface of the wafer W is impaired, which may cause a problem in the manufacturing process after the silicon carbide film is formed. For example, defocus may occur in the photolithography process.

In addition, the phenomenon in which the wafer W rides on the by-product 66 occurs because the wafer W is shifted on the susceptor during the formation of the silicon carbide film due to the centrifugal force acting on the rotating wafer W or because the placement position of the wafer W on the susceptor differs between wafers due to transfer variations and the like.

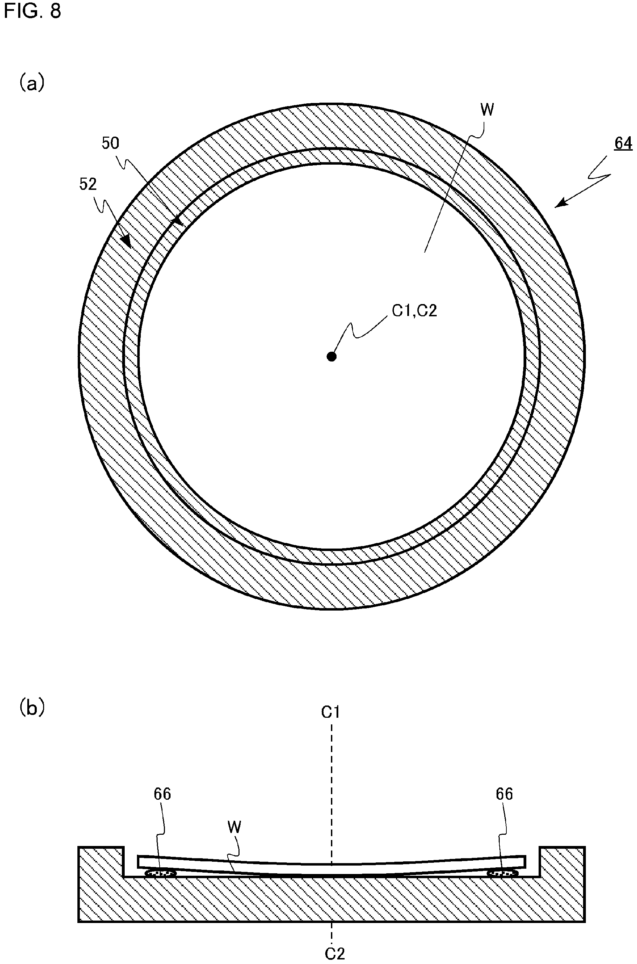

Fig. 8 is an explanatory diagram of a second problem of the holder of the first comparative example.

Fig. 8 is a schematic diagram of the holder of the first comparative example. Fig. 8(a) is a top view corresponding to Fig. 6(a), and Fig. 8(b) is a cross-sectional view corresponding to Fig. 6(b).

When a silicon carbide film is formed on the surface of the wafer W, as shown in Fig. 8(b), the wafer W may be deformed into a concave shape due to the temperature difference between the front surface and the back surface of the wafer W. In this case, the process gas may flow into the gap formed between the back surface of the wafer W and the surface of the inner region 50 of the susceptor 64, forming the by-product 66 on the surface of the inner region 50 of the susceptor 64. In addition, a silicon carbide film may be formed directly on the back surface of wafer W.

For example, the by-product 66 formed on the surface of the inner region 50 of the susceptor 64 adheres to the back surface of the wafer W. When the by-product 66 adheres to the back surface of the wafer W, the flatness of the back surface of the wafer W is impaired, which may cause a problem in the manufacturing process after the silicon carbide film is formed. In addition, even when the silicon carbide film is formed directly on the back surface of the wafer W, the film is not flat and the flatness of the back surface of the wafer W is impaired, which may cause a problem in the manufacturing process after the silicon carbide film is formed.

In addition, when the wafer W is deformed into a concave shape, the back surface of the wafer W and the support portion 54 may come into point contact with each other, particularly on the center side of the wafer W, the wafer W may not follow the rotation of the susceptor 64, or the central side of the wafer W may be actively heated to degrade the temperature distribution of the wafer W.

In addition, Fig. 8 shows, as an example, a case where the center C1 of the wafer W and the center C2 of the susceptor 64 are aligned. Even when the center C1 of the wafer W and the center C2 of the susceptor 64 are not aligned, in other words, even when the wafer W deviates from the center C2 of the susceptor 64, a problem similar to that when the center C1 of the wafer W and the center C2 of the susceptor 64 are aligned may occur.

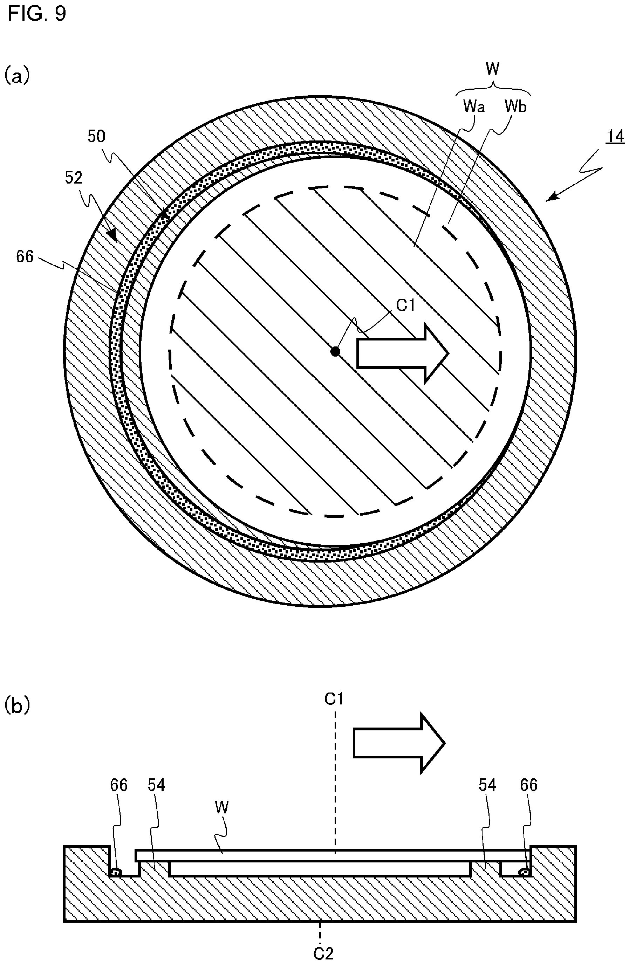

Fig. 9 is an explanatory diagram of the function and effect of the first embodiment. Fig. 9 is a schematic diagram of the holder according to the first embodiment. Fig. 9(a) is a top view, and Fig. 9(b) is a cross-sectional view. Fig. 9(b) is a cross-sectional view corresponding to Fig. 3(b).

Fig. 9 shows a case where the center C1 of the wafer W and the center C2 of the susceptor 14 are not aligned. In other words, Fig. 9 shows a case where the wafer W deviates from the center C2 of the susceptor 14.

As shown in Fig. 9(b), in the susceptor 14 according to the first embodiment, the wafer W is supported by the support portion 54. Therefore, even if the by-product 66 is formed in a region of the inner region 50 of the susceptor 64 that is not covered with the wafer W, the by-product 66 and the back surface of the wafer W do not come into contact with each other. As a result, it is possible to suppress degradation in the uniformity of the film quality of the silicon carbide film due to the wafer W riding on the by-product 66 as in the first comparative example.

In addition, the adhesion of the by-product 66 to the back surface of the wafer W due to the wafer W riding on the by-product 66 does not occur. Therefore, it is possible to suppress the occurrence of problems in the manufacturing process after the silicon carbide film is formed.

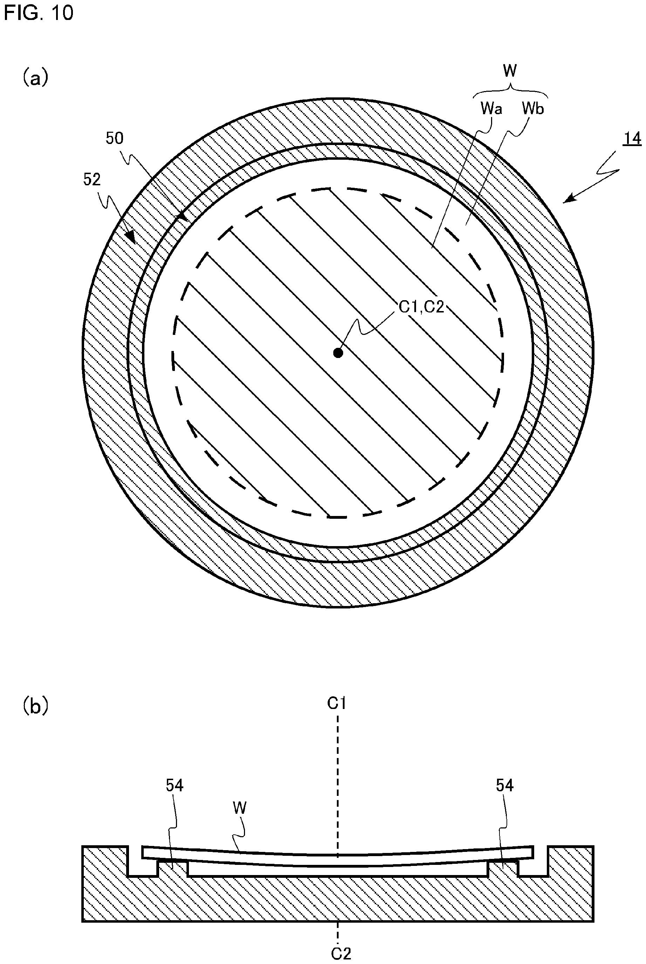

Fig. 10 is an explanatory diagram of the function and effect of the first embodiment. Fig. 10 is a schematic diagram of the holder according to the first embodiment. Fig. 10(a) is a top view, and Fig. 10(b) is a cross-sectional view. Fig. 10(b) is a cross-sectional view corresponding to Fig. 3(b).

When a silicon carbide film is formed on the surface of the wafer W, as shown in Fig. 10(b), the wafer W may be deformed into a concave shape due to the temperature difference between the front surface and the back surface of the wafer W.

As shown in Fig. 10(b), in the susceptor 14 according to the first embodiment, the wafer W is supported by the support portion 54. For this reason, a gap into which the process gas flows is less likely to be generated between the back surface of the wafer W and the susceptor 14. Therefore, even when the wafer W is deformed into a concave shape, the inflow of process gas between the back surface of the wafer W and the front surface of the susceptor 64 as in the first comparative example is suppressed.

Therefore, the adhesion of the by-product 66 formed on the back surface of the wafer W is also suppressed. In addition, the formation of a silicon carbide film directly on the back surface of the wafer W is also suppressed. As a result, it is possible to suppress the occurrence of problems in the manufacturing process after the silicon carbide film is formed.

In addition, Fig. 10 shows, as an example, a case where the center C1 of the wafer W and the center C2 of the susceptor 14 are aligned. Even when the center C1 of the wafer W and the center C2 of the susceptor 14 are not aligned, in other words, even when the wafer W deviates from the center C2 of the susceptor 14, the same effect as when the center C1 of the wafer W and the center C2 of the susceptor 14 are aligned can be obtained.

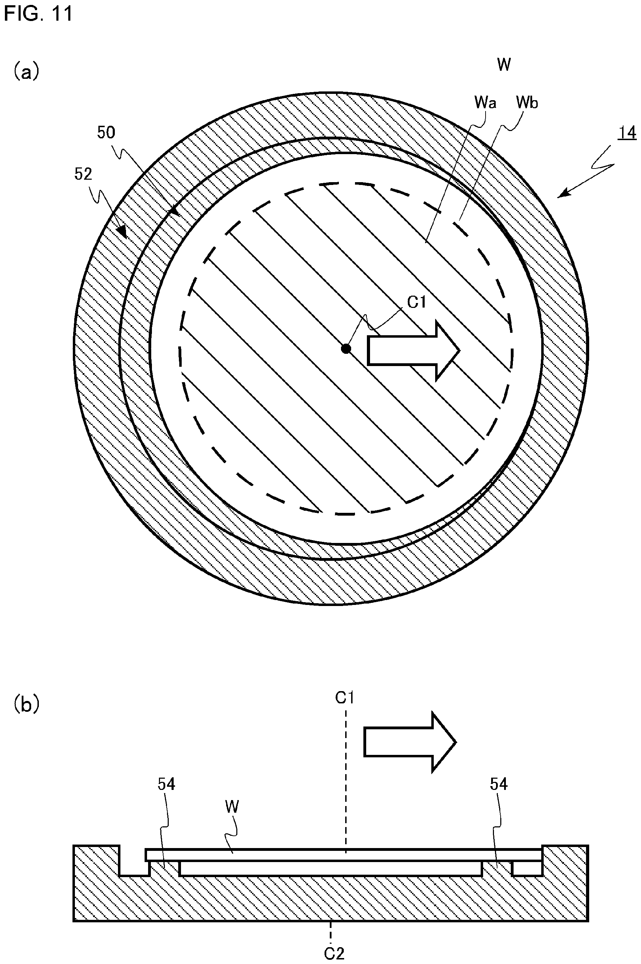

Fig. 11 is an explanatory diagram of the function and effect of the first embodiment. Fig. 11 is a schematic diagram of the holder according to the first embodiment. Fig. 11(a) is a top view, and Fig. 11(b) is a cross-sectional view. Fig. 11(b) is a cross-sectional view corresponding to Fig. 3(b).

Fig. 11 shows a case where the center C1 of the wafer W and the center C2 of the susceptor 14 are not aligned. In other words, Fig. 11 shows a case where the wafer W deviates from the center C2 of the susceptor 14. Fig. 11 shows a case where the center C1 of the wafer W deviates from the center C2 of the susceptor 14 to the right in the diagram.

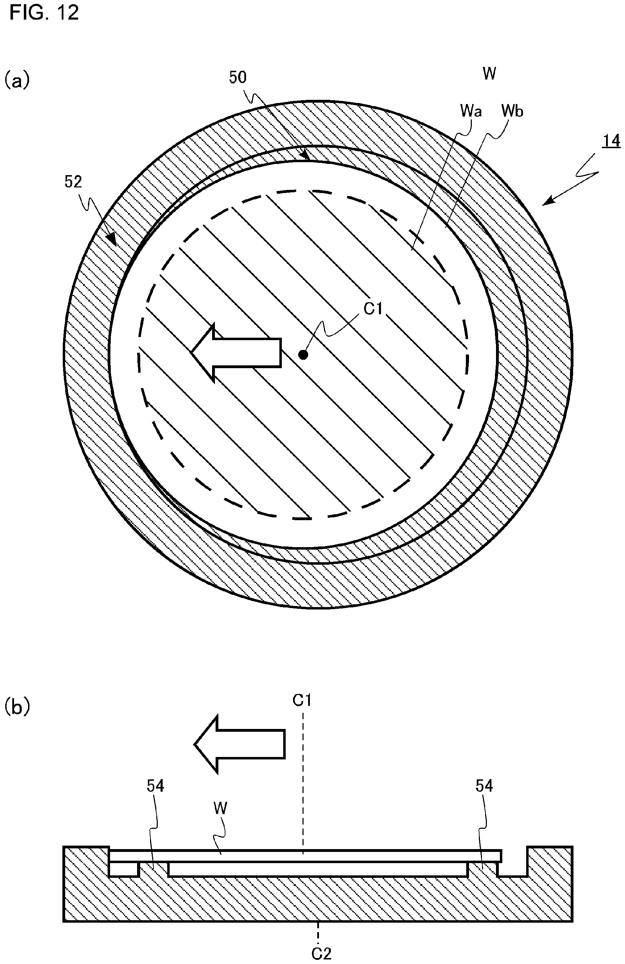

Fig. 12 is an explanatory diagram of the function and effect of the first embodiment. Fig. 12 is a schematic diagram of the holder according to the first embodiment. Fig. 12(a) is a top view, and Fig. 12(b) is a cross-sectional view. Fig. 12(b) is a cross-sectional view corresponding to Fig. 3(b).

Fig. 12 shows a case where the center C1 of the wafer W and the center C2 of the susceptor 14 are not aligned. In other words, Fig. 12 shows a case where the wafer W deviates from the center C2 of the susceptor 14. Fig. 12 shows a case where the center C1 of the wafer W deviates from the center C2 of the susceptor 14 to the left in the diagram.

In the susceptor 14 according to the first embodiment, the following Expression 1 is satisfied for the radius R1 of the wafer W, the radius R4 of the outer peripheral edge of the support portion 54, and the distance D1.

$$R1 - D1 > R4...(\text{Expression 1})$$

Expression 1 means that, even when the center C1 of the wafer W deviates from the center C2 of the susceptor 14 by D1 in one direction, the edge of the wafer W on a side opposite to the deviation direction is located closer to the outer region 52 than the outer peripheral edge E2 of the support portion 54. Therefore, as shown in Figs. 11(b) and 12(b), even when the center C1 of the wafer W deviates from the center C2 of the susceptor 14, the top surface 54s of the support portion 54 is not exposed.

Between the back surface of the wafer W and the support portion 54, heat exchange between the wafer W and the support portion 54 occurs due to heat conduction. That is, inflow of heat from the wafer W to the support portion 54 or outflow of heat from the wafer W to the support portion 54 occurs. For example, when the temperature of the wafer W is lower than the temperature of the support portion 54, the inflow of heat from the wafer W to the support portion 54 occurs. On the other hand, when the temperature of the wafer W is higher than the temperature of the support portion 54, the outflow of heat from the wafer W to the support portion 54 occurs.

If the top surface 54s of the support portion 54 is exposed, the area of the support portion 54 in contact with the back surface of the wafer W changes depending on the position of the wafer W. For example, the degree of heat exchange at a position of the wafer W near a portion where the top surface 54s of the support portion 54 is exposed is lower than that at a position of the wafer W near a portion where the top surface 54s of the support portion 54 is not exposed.

For this reason, the degree of heat exchange between the wafer W and the support portion 54 changes depending on the position of the wafer W. Therefore, the uniformity of the temperature of the wafer W is degraded. In the susceptor 14 according to the first embodiment, since the top surface 54s of the support portion 54 is not exposed, it is possible to suppress degradation in the uniformity of the temperature of the wafer W.

In addition, in the susceptor 14 according to the first embodiment, since the top surface 54s of the support portion 54 is not exposed, it is possible to suppress the adhesion of a by-product to the top surface 54s of the support portion 54 when forming a silicon carbide film on the surface of the wafer W. Therefore, it is possible to suppress the adhesion of the by-product 66 to the back surface of the wafer W due to the wafer W riding on the by-product 66.

The vapor phase growth apparatus 100 according to the first embodiment includes the second heater 42 to heat the wafer W placed on the susceptor 14 from above. The second heater 42 heats the wafer W placed on the susceptor 14 from the outer peripheral side of the susceptor 14.

The outer region 52 is close to the second heater 42 and accordingly, the temperature of the outer region 52 is likely to rise during the formation of a silicon carbide film. For this reason, when the center C1 of the wafer W and the center C2 of the susceptor 14 are misaligned and the wafer W comes into contact with the outer region 52, the temperature of a portion of the wafer W in contact with the outer region 52 may be higher than the temperature of other portions. In such a case, the vicinity of the edge Ex of the film quality guaranteed region Wa around the portion of the wafer W in contact with the outer region 52 is likely to have a high temperature. That is, the film quality is likely to change in the vicinity of the edge Ex of the film quality guaranteed region Wa that has reached a high temperature.

However, in the susceptor 14 according to the first embodiment, the distance X between the outer peripheral edge E2 of the support portion 54 and the inner peripheral edge E3 of the outer region 52 is equal to or less than 6 mm. In the susceptor 14 according to the first embodiment, as compared with the case where the distance X is larger than 6 mm, the distance between the portion of the wafer W in contact with the outer region 52 and the support portion 54 is short. Therefore, heat is likely to flow from the portion of the wafer W in contact with the outer region 52 to the support portion 54 in contact with the back surface of the wafer W through the wafer W.

In addition, in the susceptor 14 according to the first embodiment, the width w of the support portion 54 is equal to or more than 3 mm. Since the susceptor 14 according to the first embodiment has a larger contact area than in the case where the width w of the support portion 54 is less than 3 mm, heat exchange is promoted.

As a result, around the portion of the wafer W in contact with the outer region 52, it is possible to suppress a temperature increase in the vicinity of the edge Ex of the film quality guaranteed region Wa. That is, the temperature uniformity in the film quality guaranteed region Wa of the wafer W is improved.

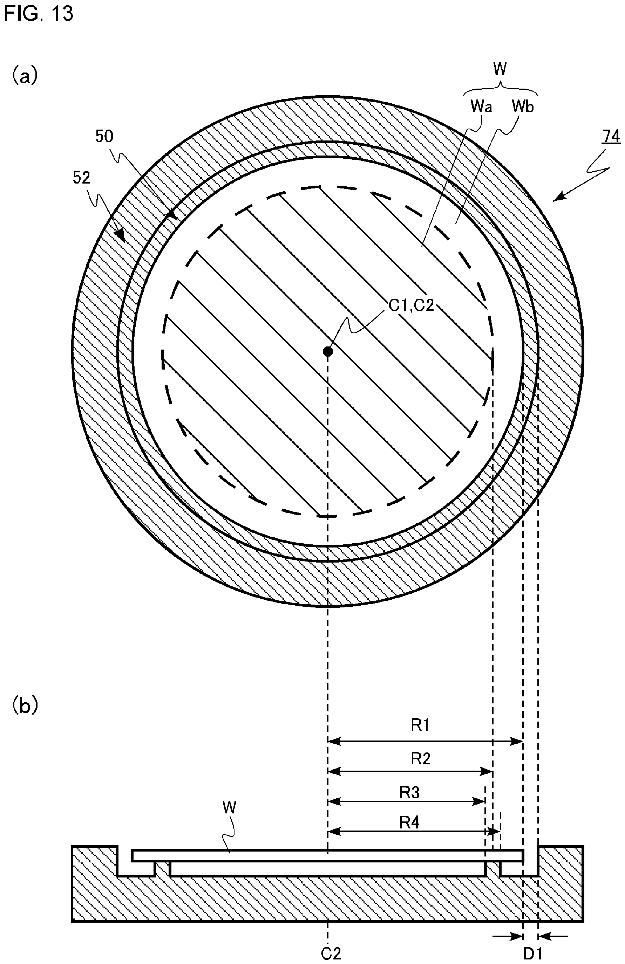

Fig. 13 is a schematic diagram of a holder of a second comparative example. Fig. 13(a) is a top view, and Fig. 13(b) is a cross-sectional view.

Fig. 13 is a diagram showing a state in which the wafer W is placed on a susceptor 74. Fig. 13 shows a case where the center C1 of the wafer W and the center C2 of the susceptor 64 are aligned.

The susceptor 74 of the second comparative example is different from the susceptor 14 according to the first embodiment in that the following Expressions 2 and 3 are not satisfied for the radius R2 of the film quality guaranteed region Wa of the wafer W, the radius R3 of the inner peripheral edge of the support portion 54, the radius R4 of the outer peripheral edge of the support portion 54, and the distance D1.

$$R2 - D1 > R3 ...(\text{Expression } 2)$$

$$R2 + D1 < R4 ...(\text{Expression } 3)$$

The susceptor 74 of the second comparative example satisfies the following Expressions 2' and 3'.

$$R2 - D1 < R3 ...(\text{Expression } 2')$$

$$R2 + D1 > R4 ...(\text{Expression } 3')$$

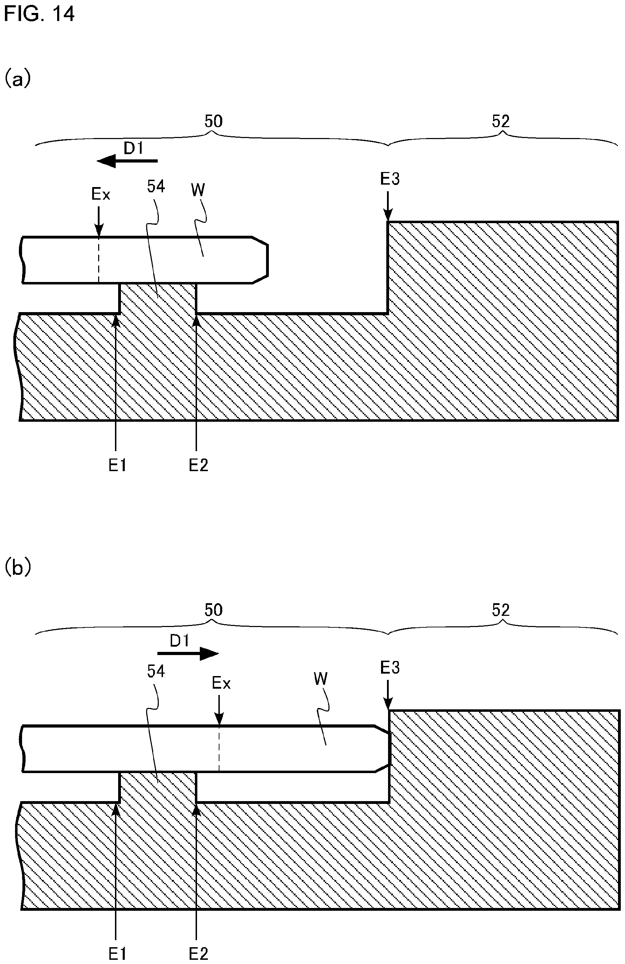

Fig. 14 is an enlarged schematic cross-sectional view of a holder of the second comparative example. Fig. 14 is a cross-sectional view of a part of the inner region 50 including the support portion 54 and the outer region 52. Fig. 14(a) shows a state in which an arbitrary edge of the wafer W deviates inward, that is, leftward in the diagram by D1, and Fig. 14(b) shows a state in which an arbitrary edge of the wafer W deviates outward, that is, rightward in the diagram by D1.

Expression 2' means that, as shown in Fig. 14(a), when an arbitrary edge of the wafer W deviates inward by D1 with respect to the susceptor 14, the edge (Ex in Fig. 14) of the film quality guaranteed region Wa is located closer to the center of the susceptor 74 than the inner peripheral edge E1 of the support portion 54. In addition, Expression 3' means that, as shown in Fig. 14(b), when an arbitrary edge of the wafer W deviates outward by D1, the edge Ex of the film quality guaranteed region Wa is located closer to the outer periphery of the susceptor 74 than the outer peripheral edge E2 of the support portion 54.

Since the edge Ex of the film quality guaranteed region Wa deviates from the support portion 54, the in-plane film quality uniformity of the wafer W is degraded. It is considered that this is because the heat exchange between the support portion 54 and the vicinity of the edge Ex of the film quality guaranteed region Wa is insufficient and accordingly, the temperature in the vicinity of the edge Ex of the film quality guaranteed region Wa is likely to change and the in-plane temperature uniformity of the wafer W is degraded.

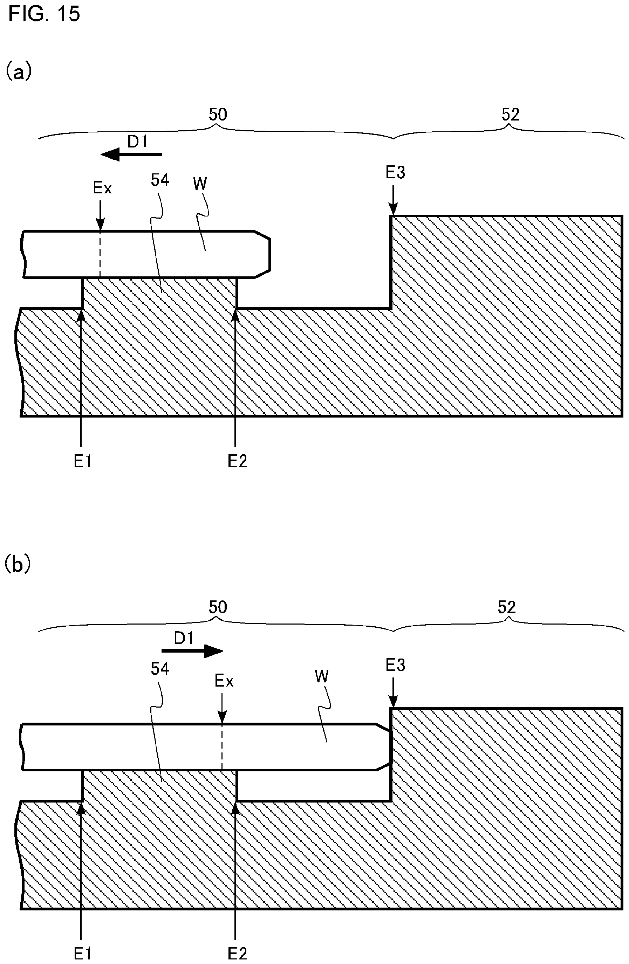

Fig. 15 is an enlarged schematic cross-sectional view of the holder according to the first embodiment. Fig. 15 is a cross-sectional view of a part of the inner region 50 including the support portion 54 and the outer region 52. Fig. 15(a) shows a state in which an arbitrary edge of the wafer W deviates inward, that is, leftward in the diagram by D1, and Fig. 15(b) shows a state in which an arbitrary edge of the wafer W deviates outward, that is, rightward in the diagram by D1.

The susceptor 14 according to the first embodiment satisfies the following Expressions 2 and 3.

$$R2 - D1 > R3...(\text{Expression 2})$$

$$R2 + D1 < R4...(\text{Expression 3})$$

Expression 2 means that, as shown in Fig. 15(a), when an arbitrary edge of the wafer W deviates inward by D1 with respect to the susceptor 14, the edge (Ex in Fig. 15) of the film quality guaranteed region Wa is located closer to the outer periphery of the susceptor 14 than the inner peripheral edge E1 of the support portion 54. That is, Expression 2 means that the edge Ex of the film quality guaranteed region Wa is located on the support portion 54.

In addition, Expression 3 means that, as shown in Fig. 15(b), when an arbitrary edge of the wafer W deviates outward by D1, the edge Ex of the film quality guaranteed region Wa is located closer to the inner periphery of the susceptor 14 than the outer peripheral edge E2 of the support portion 54. That is, Expression 3 means that the edge Ex of the film quality guaranteed region Wa is located on the support portion 54.

In the susceptor 14 according to the first embodiment, even when the wafer W deviates with respect to the susceptor 14, the edge Ex of the film quality guaranteed region Wa is always located on the support portion 54. Therefore, heat exchange between the support portion 54 and the vicinity of the edge Ex of the film quality guaranteed region Wa is promoted. As a result, the in-plane film quality uniformity of the wafer W is improved.

It is preferable that the difference between the radius R1 of the wafer W and the radius R2 of the film quality guaranteed region Wa is equal to or more than 3 mm and equal to or less than 6 mm. By setting the difference to be equal to or more than 3 mm, the film quality of the wafer W can be easily guaranteed. In addition, by setting the difference to be equal to or less than 6 mm, the percentage of the film quality guaranteed region Wa in the plane of the wafer W increases.

It is preferable that the distance D1 between the outer peripheral edge of the wafer W and the inner peripheral edge E3 of the outer region 52 is equal to or more than 0.5 mm and equal to or less than 3 mm. By setting the distance D1 to be equal to or more than 0.5 mm, the wafer W can be easily placed on the susceptor 14 by using a transfer robot or the like. In addition, by setting the distance D1 to be equal to or less than 3 mm, the process gas flows from between the outer peripheral edge of the wafer W and the inner peripheral edge E3 of the outer region 52, so that the formation of a by-product between the support portion 54 and the inner peripheral edge E3 of the outer region 52 is easily suppressed.

For example, if a by-product is formed between the support portion 54 and the inner peripheral edge E3 of the outer region 52, the by-product may sublimate and adhere to the back surface of the wafer W again. From the viewpoint of suppressing the re-adhesion of a by-product to the wafer W due to sublimation, it is preferable to suppress the formation of the by-product between the support portion 54 and the inner peripheral edge E3 of the outer region 52.

It is preferable that the radius R3 of the inner peripheral edge E1 of the support portion 54 is equal to or more than 85% of the radius R1 of the wafer W. By setting the radius R3 to be equal to or more than 85% of the radius R1, the support portion 54 can hold the back surface of the outer peripheral portion of the wafer W. Therefore, for example, when the wafer W is deformed into a concave shape, it is possible to prevent the back surface of the wafer W and the support portion 54 from coming into point contact with each other. As a result, it is possible to suppress the occurrence of a situation in which the wafer W does not follow the rotation of the susceptor 14. In addition, it is possible to suppress the degradation of the in-plane temperature distribution of the wafer W due to point contact between the back surface of the wafer W and the support portion 54. In addition, when the wafer W is deformed into a concave shape, it is possible to suppress the occurrence of a situation in which the process gas flows between the back surface of the wafer W and the support portion 54 to form a by-product.

In addition, by setting the radius R3 to be equal to or more than 85% of the radius R1, it is possible to reduce the area of the back surface of the wafer W exposed to the outside of the outer peripheral edge E2 of the support portion 54. Therefore, it is possible to suppress the adhesion of a by-product due to the process gas flowing to the back surface of the wafer W.

When the wafer W is placed on the susceptor 14, it is preferable that the position of the top surface 52s of the outer region 52 is higher than the position of the surface of the wafer W, for example. It is possible to suppress the occurrence of a situation in which the wafer W comes off the susceptor 14 while the susceptor 14 is rotating.

It is preferable that the height h of the support portion 54 is equal to or more than 0.5 mm and equal to or less than 3 mm. When the height h is less than 0.5 mm, the distance between the wafer W and the inner region is short. For this reason, the in-plane temperature distribution of the wafer W is easily affected by slight warping of the wafer. That is, variations in the warping of the wafer W tend to cause differences in the temperature distribution of the wafer W between wafers, resulting in the poor reproducibility of the film quality. In addition, since it is difficult to completely match the center of gravity of the wafer W with the center of rotation, a centrifugal force acts on the wafer W. Therefore, if the height h is set to be larger than 3 mm, the moment acting on the inner peripheral edge of the outer region 52 increases. As a result, the susceptor 14 slightly floats on a side opposite to the direction, in which the centrifugal force acts on the wafer W, to cause vibrations, so that the wafer W is likely to come off the susceptor or the reproducibility of the film quality is likely to become poor.

It is preferable that the width w of the support portion 54 is equal to or less than 10 mm. By setting the width w to be equal to or less than 10 mm, when the wafer W is deformed into a concave shape, it becomes easy to suppress the occurrence of a situation in which the process gas flows between the back surface of the wafer W and the support portion 54 to form a by-product.

As described above, according to the vapor phase growth apparatus according to the first embodiment, it is possible to improve the uniformity of the temperature of the substrate. Therefore, the uniformity of the properties of the film formed on the substrate is improved.

(Second Embodiment)

A vapor phase growth apparatus according to a second embodiment is different from that of the first embodiment in that the inner region does not have a disc shape but has a ring shape. Hereinafter, the description of a part of the content overlapping the first embodiment will be omitted.

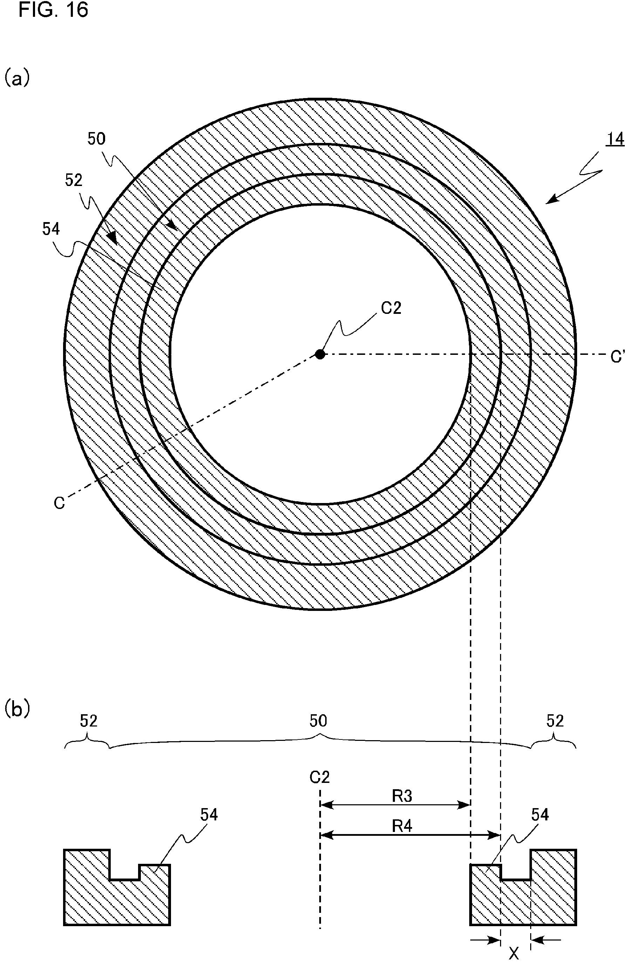

Fig. 16 is a schematic diagram of a holder according to the second embodiment. Fig. 16(a) is a top view, and Fig. 16(b) is a cross-sectional view taken along the line CC' of Fig. 16(a).

A susceptor 14 has a center C2. The susceptor 14 includes an inner region 50 and an outer region 52. The outer region 52 surrounds the inner region 50. The outer region 52 surrounds a wafer W when the wafer W is placed on the susceptor 14.

The inner region 50 has a ring shape. There is an opening in the center of the inner region 50. The outer region 52 has an annular shape.

As described above, according to the vapor phase growth apparatus according to the second embodiment, it is possible to improve the uniformity of the temperature of the substrate as in the first embodiment. Therefore, the uniformity of the properties of the film formed on the substrate is improved.

(Third Embodiment)

A vapor phase growth apparatus according to a third embodiment is different from that of the first embodiment in that there are a plurality of protrusions on the inner peripheral side of the outer region of the holder. Hereinafter, the description of a part of the content overlapping the first embodiment will be omitted.

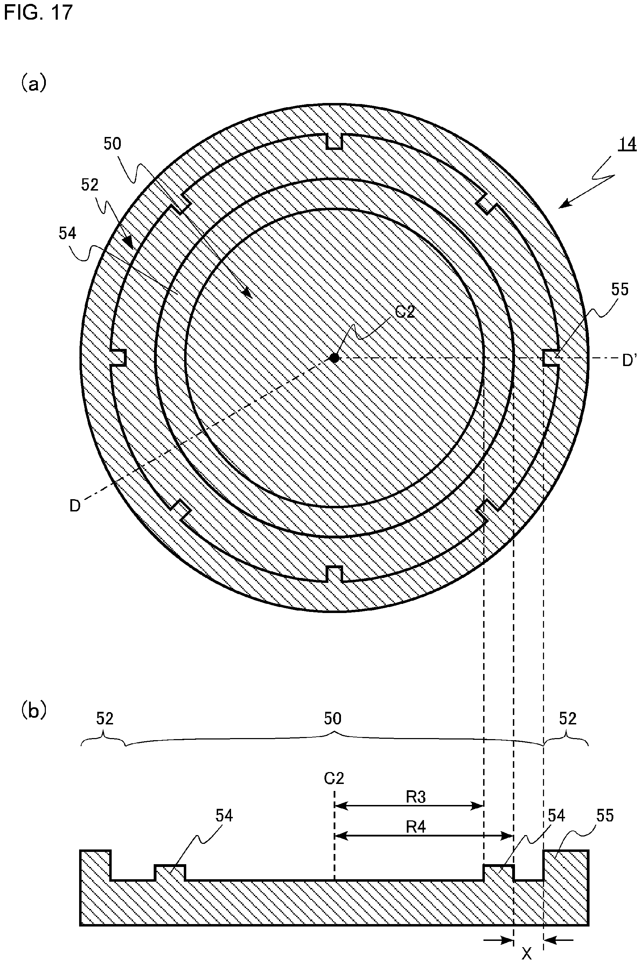

Fig. 17 is a schematic diagram of a holder according to the third embodiment. Fig. 17(a) is a top view, and Fig. 17(b) is a cross-sectional view taken along the line DD' of Fig. 17(a).

The susceptor 14 includes an inner region 50 and an outer region 52. The outer region 52 surrounds the inner region 50. The outer region 52 surrounds a wafer W when the wafer W is placed on the susceptor 14.

The susceptor 14 has a plurality of protrusions 55 on the inner peripheral side of the outer region 52.

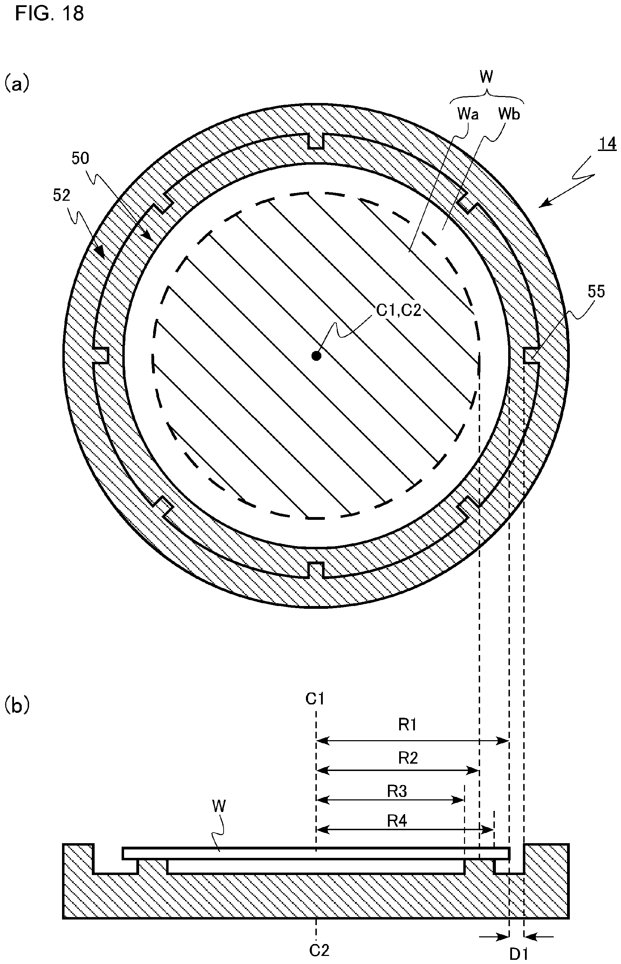

Fig. 18 is a schematic diagram of a holder according to the third embodiment. Fig. 18(a) is a top view corresponding to Fig. 17(a), and Fig. 18(b) is a cross-sectional view corresponding to Fig. 17(b).

Fig. 18 is a diagram showing a state in which the wafer W is placed on the susceptor 14. Fig. 18 shows a case where the center C1 of the wafer W and the center C2 of the susceptor 14 are aligned.

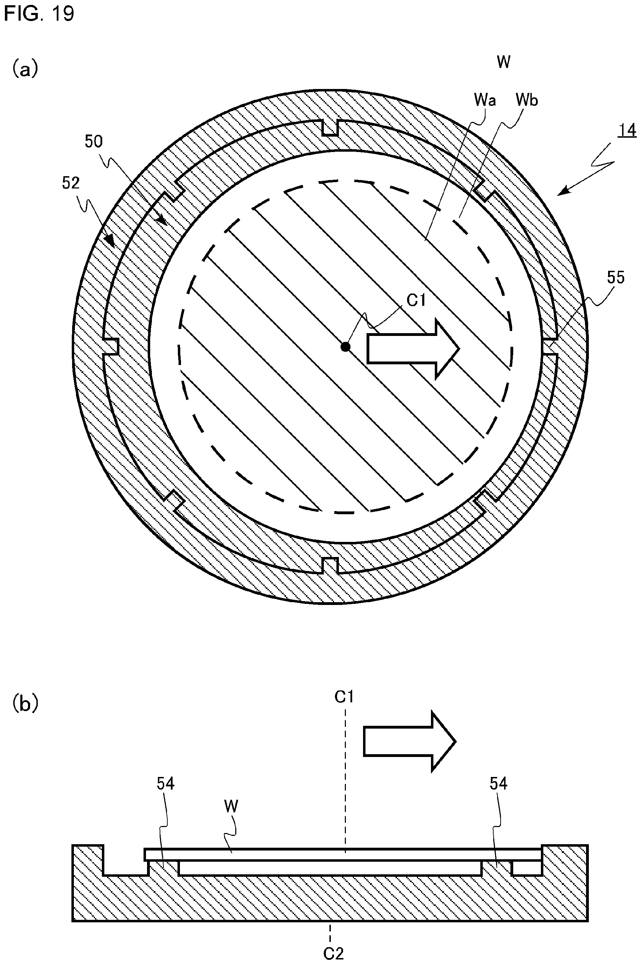

Fig. 19 is an explanatory diagram of the function and effect of the third embodiment. Fig. 19 is a schematic diagram of a holder according to the third embodiment. Fig. 19(a) is a top view, and Fig. 19(b) is a cross-sectional view. Fig. 19(b) is a cross-sectional view corresponding to Fig. 18(b).

Fig. 19 shows a case where the center C1 of the wafer W and the center C2 of the susceptor 14 are not aligned. In other words, Fig. 19 shows a case where the wafer W deviates from the center C2 of the susceptor 14.

When the wafer W deviates from the center C2 of the susceptor 14, the outer periphery of the wafer W comes into contact with the outer region 52 at the protrusions 55. Therefore, the contact area between the outer periphery of the wafer W and the outer region 52 is smaller than, for example, that in the case of the susceptor 14 according to the first embodiment. As a result, the inflow of heat from the outer region 52 is suppressed to improve the uniformity of the temperature of the wafer W.

As described above, according to the vapor phase growth apparatus according to the third embodiment, it is possible to further improve the uniformity of the temperature of the substrate as compared with the first embodiment. Therefore, the uniformity of the properties of the film formed on the substrate is further improved.

(Fourth Embodiment)

A vapor phase growth apparatus according to a fourth embodiment is different from the vapor phase growth apparatus according to the first embodiment in that the outer region of a holder includes a first member containing carbon and a second member that is provided on the first member, is separable from the first member, and has at least a surface containing silicon carbide. Hereinafter, the description of a part of the content overlapping the first embodiment will be omitted.

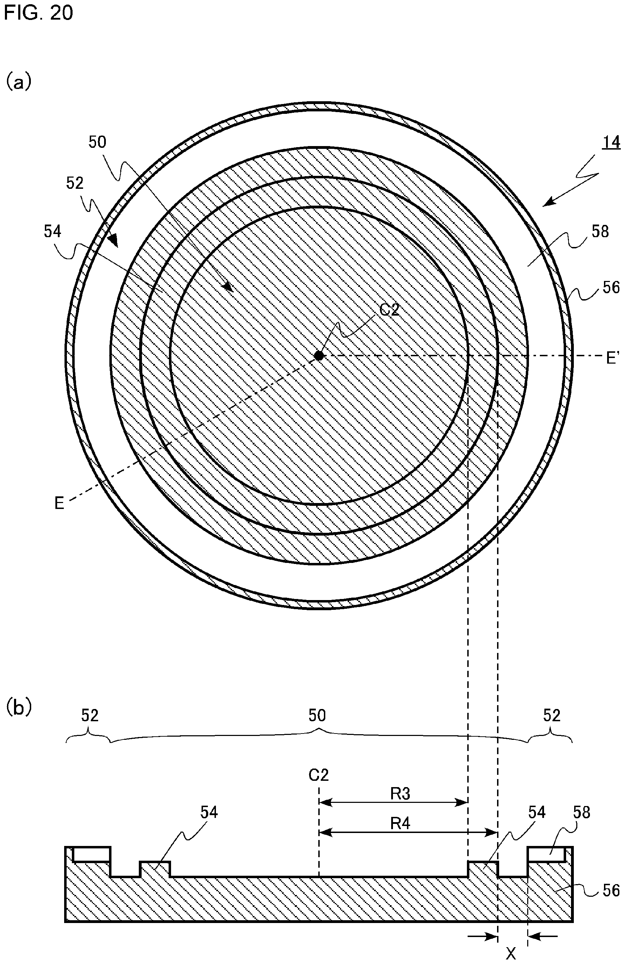

Fig. 20 is a schematic diagram of a holder according to the fourth embodiment. Fig. 20(a) is a top view, and Fig. 20(b) is a cross-sectional view taken along the line EE' of Fig. 20(a).

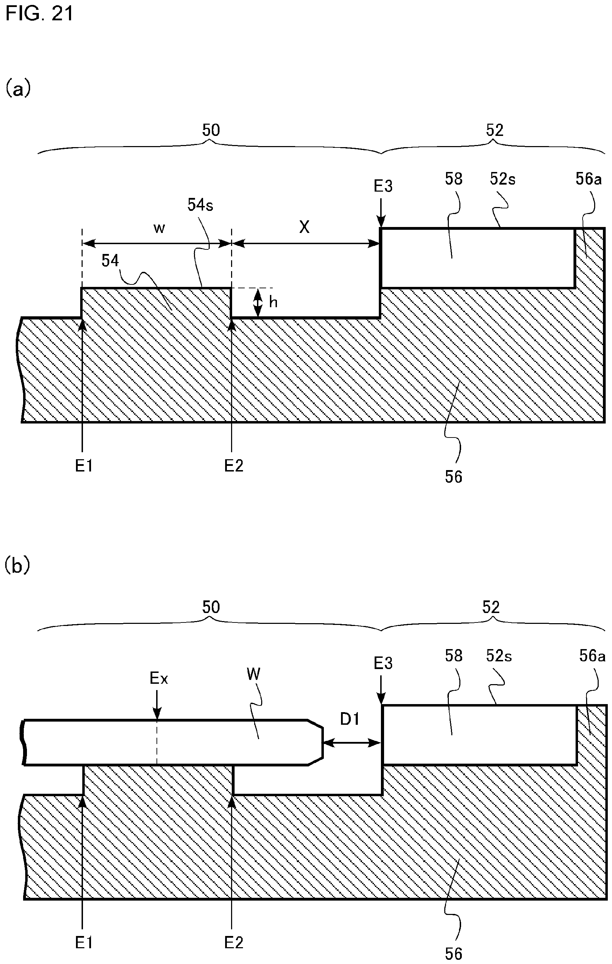

Fig. 21 is an enlarged schematic cross-sectional view of the holder according to the fourth embodiment. Fig. 21 is a cross-sectional view of a part of the inner region 50 including the support portion 54 and the outer region 52. Fig. 21(a) shows a state in which the wafer W is not placed, and Fig. 21(b) shows a state in which the wafer W is placed.

A susceptor 14 has a center C2. The susceptor 14 includes an inner region 50 and an outer region 52. The outer region 52 surrounds the inner region 50. The outer region 52 surrounds a wafer W when the wafer W is placed on the susceptor 14.

The outer region 52 includes a first member 56 and a second member 58. The second member 58 is placed on the first member 56. The second member 58 has a ring shape.

An outer periphery fixing portion 56a that protrudes upward is provided at the outer peripheral edge of the first member 56. The outer periphery fixing portion 56a surrounds the second member 58. The second member 58 placed on the first member 56 is laterally fixed by the outer periphery fixing portion 56a. The second member 58 and the first member 56 can be separated from each other. In addition, a structure may be adopted in which the upper portion of the second member 58 extends toward the first member 56 and the upper portion extending to the outside of the second member is placed on the first member 56.

The boundary between the first member 56 and the second member 58 is located below the top surface of the wafer W, for example. Therefore, when the wafer W deviates outward by D1, a part of the wafer W comes into contact with a part of the second member 58.

The first member 56 and the second member 58 are formed of different materials. The first member 56 contains carbon (C). The second member 58 contains silicon carbide. At least the surface of second member 58 contains silicon carbide. The second member 58 is, for example, polycrystalline silicon carbide. The second member 58 is, for example, 3C-SiC.

When forming a film on the wafer W, a by-product is formed on the top surface 52s of the outer region 52. By making the second member 58 separable from the first member 56, it becomes easy to clean the susceptor 14.

It is conceivable that a by-product formed on the top surface 52s of the outer region 52 is peeled off from the top surface 52s by the application of stress due to the temperature change of the susceptor 14. When the by-product peels off, the amount of dust in the reactor 10 increases, and the quality of the formed film is likely to be lowered. In addition, a large stress may be generated in the susceptor 14 due to the by-product formed on the top surface 52s of the outer region 52, which may cause the susceptor 14 to warp. If the susceptor 14 warps, the temperature distribution of the wafer W is degraded, and the uniformity of the film quality of the formed film is likely to be degraded.

For example, when forming a silicon carbide film, the main component of the by-product formed on the top surface 52s is silicon carbide. Since the surface of the second member 58 contains silicon carbide, the thermal expansion coefficients of the second member 58 and the by-product become close to each other. Therefore, since the peeling of the by-product from the top surface 52s is suppressed, the film quality of the formed film is easily improved. In addition, since the warping of the susceptor 14 due to the by-product is also suppressed, the uniformity of the film quality of the formed film is easily improved.

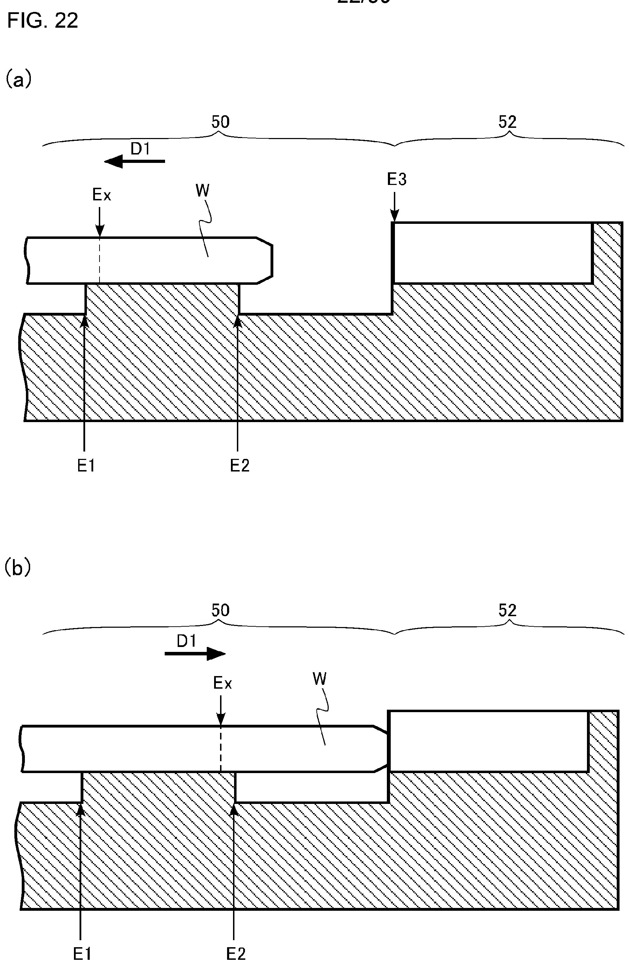

Fig. 22 is an enlarged schematic cross-sectional view of the holder according to the fourth embodiment. Fig. 22 is a cross-sectional view of a part of the inner region 50 including the support portion 54 and the outer region 52. Fig. 22(a) shows a state in which an arbitrary edge of the wafer W deviates inward, that is, leftward in the diagram by D1, and Fig. 22(b) shows a state in which an arbitrary edge of the wafer W deviates outward, that is, rightward by D1.

In the susceptor 14 according to the fourth embodiment, even when the wafer W deviates with respect to the susceptor 14, the edge Ex of the film quality guaranteed region Wa is always located on the support portion 54. Therefore, heat exchange between the support portion 54 and the vicinity of the edge Ex of the film quality guaranteed region Wa is promoted. As a result, the in-plane film quality uniformity of the wafer W is improved.

As shown in Fig. 22(b), when an arbitrary edge of the wafer W deviates outward by D1, the wafer W comes into contact with the second member 58.

The first member 56 and the second member 58 are formed of different materials. For this reason, the boundary between the first member 56 and the second member 58 serves as a heat resistor. Therefore, when the second member 58 is heated to a high temperature by the second heater 42, the flow of heat from the second member 58 to the first member 56 is suppressed. Therefore, for example, the second member 58 is likely to have a higher temperature than when the first member 56 and the second member 58 are formed of the same material. As a result, due to the heat flowing from the portion of the wafer W in contact with the second member 58, the vicinity of the edge Ex of the film quality guaranteed region Wa around the portion of the wafer W in contact with the second member 58 is likely to have a high temperature.

In the susceptor 14 according to the fourth embodiment, heat is likely to flow from the portion of the wafer W in contact with the second member 58 to the support portion 54 in contact with the back surface of the wafer W through the wafer W. Therefore, it is easy to suppress the occurrence of a situation in which the vicinity of the edge Ex of the film quality guaranteed region Wa around the portion of the wafer W in contact with the second member 58 has a high temperature.

As described above, according to the vapor phase growth apparatus according to the fourth embodiment, it is possible to improve the uniformity of the temperature of the substrate as in the first embodiment. Therefore, the uniformity of the properties of the film formed on the substrate is improved.

(Fifth Embodiment)

A vapor phase growth apparatus according to a fifth embodiment is different from the vapor phase growth apparatus according to the fourth embodiment in that an inner periphery fixing portion that protrudes upward is provided at the inner peripheral edge of the first member in the outer region of the holder. Hereinafter, the description of a part of the content overlapping the first and fourth embodiments will be omitted.

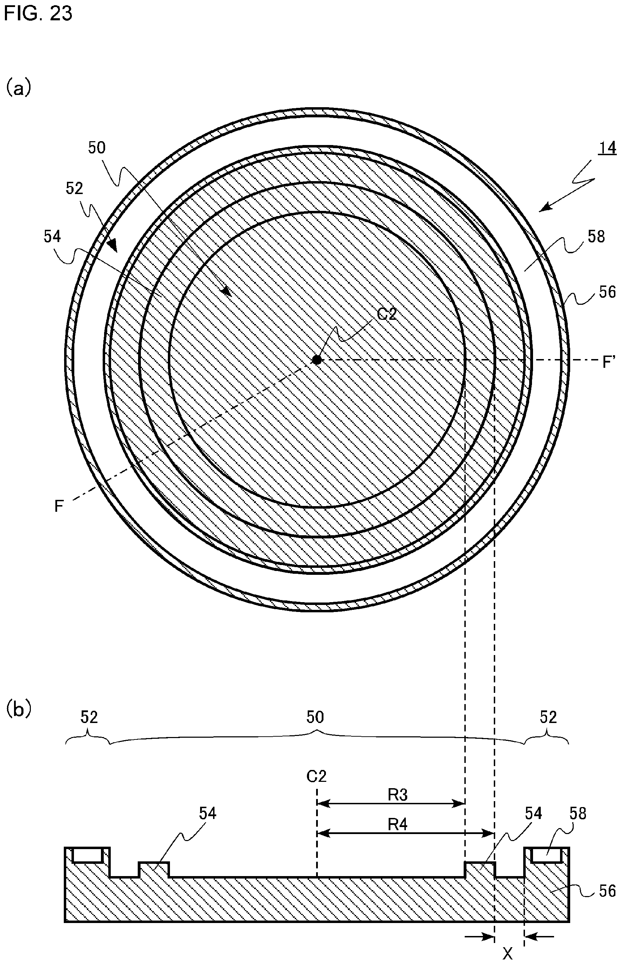

Fig. 23 is a schematic diagram of a holder according to the fifth embodiment. Fig. 23(a) is a top view, and Fig. 23(b) is a cross-sectional view taken along the line FF' of Fig. 23(a).

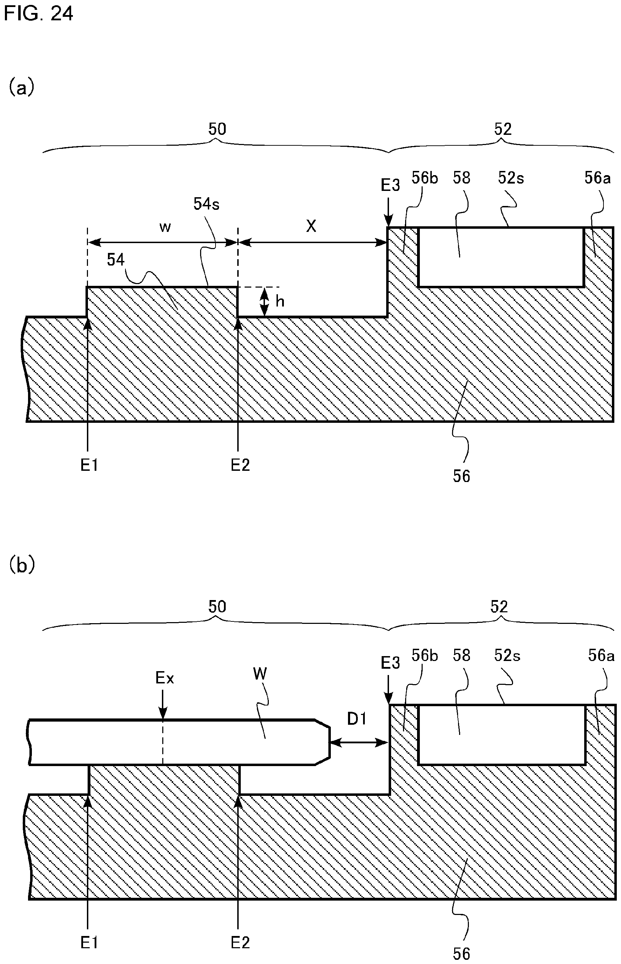

Fig. 24 is an enlarged schematic cross-sectional view of the holder according to the fifth embodiment. Fig. 24 is a cross-sectional view of a part of the inner region 50 including the support portion 54 and the outer region 52. Fig. 24(a) shows a state in which the wafer W is not placed, and Fig. 24(b) shows a state in which the wafer W is placed.

A susceptor 14 has a center C2. The susceptor 14 includes an inner region 50 and an outer region 52. The outer region 52 surrounds the inner region 50. The outer region 52 surrounds a wafer W when the wafer W is placed on the susceptor 14.

The outer region 52 includes a first member 56 and a second member 58. The second member 58 is placed on the first member 56. The second member 58 has a ring shape.

An outer periphery fixing portion 56a that protrudes upward is provided at the outer peripheral edge of the first member 56. The outer periphery fixing portion 56a surrounds the second member 58.

In addition, an inner periphery fixing portion 56b that protrudes upward is provided at the inner peripheral edge of the first member 56. The second member 58 surrounds the inner periphery fixing portion 56b.

The second member 58 placed on the first member 56 is laterally fixed by the inner periphery fixing portion 56b and the outer periphery fixing portion 56a. The second member 58 and the first member 56 can be separated from each other. In addition, a structure may be adopted in which the upper portion of the second member 58 extends toward the outer periphery fixing portion 56a and the upper portion extending to the outside of the second member 58 is placed on the outer periphery fixing portion 56a.

In the susceptor 14 according to the fifth embodiment, the wafer W does not come into direct contact with the second member 58 even if an arbitrary edge of the wafer W deviates outward by D1. Therefore, even when the second member 58 is heated to a high temperature by the second heater 42, the flow of heat from the second member 58 to the wafer W is suppressed. As a result, as compared with a case where the susceptor 14 according to the fourth embodiment is used, the uniformity of the temperature of the wafer W is maintained.

As described above, according to the vapor phase growth apparatus according to the fifth embodiment, it is possible to improve the uniformity of the temperature of the substrate as in the first embodiment. Therefore, the uniformity of the properties of the film formed on the substrate is improved.

(Sixth Embodiment)

A vapor phase growth apparatus according to a sixth embodiment is different from that of the fourth embodiment in that the holder has a base portion and a detachable portion, which is separable, on the base portion. Hereinafter, the description of a part of the content overlapping the first and fourth embodiments will be omitted.

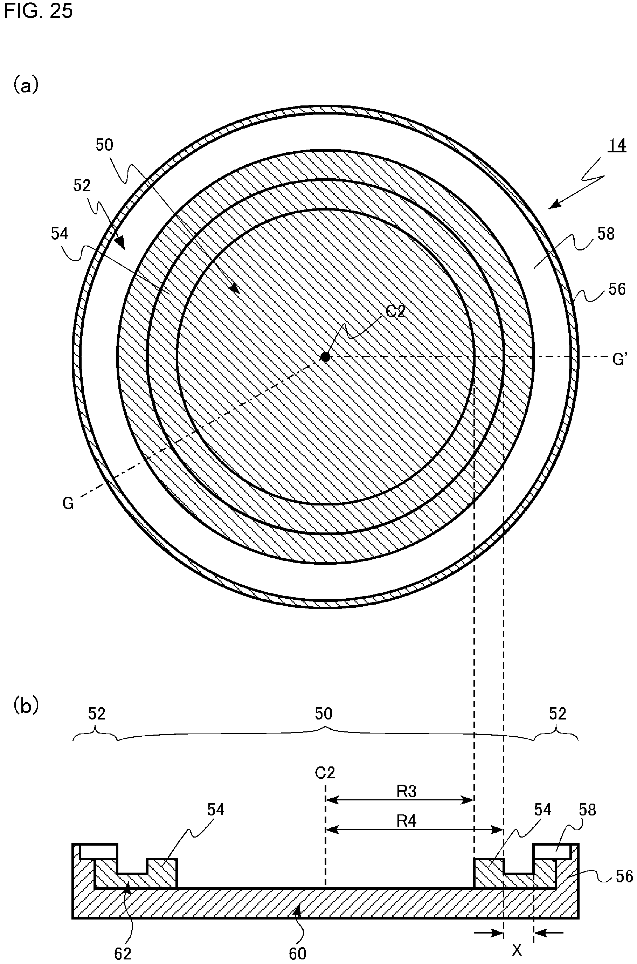

Fig. 25 is a schematic diagram of a holder according to the sixth embodiment. Fig. 25(a) is a top view, and Fig. 25(b) is a cross-sectional view taken along the line GG' of Fig. 25(a).

A susceptor 14 has a center C2. The susceptor 14 includes an inner region 50 and an outer region 52. The outer region 52 surrounds the inner region 50. The outer region 52 surrounds a wafer W when the wafer W is placed on the susceptor 14.

The susceptor 14 includes a base portion 60 and a detachable portion 62. The detachable portion 62 is provided on the base portion 60. The detachable portion 62 is separable from the base portion 60.

A part of the inner region 50 and a part of the outer region 52 are included in the base portion 60. Another part of the inner region 50 is included in the detachable portion 62.

The base portion 60 and the detachable portion 62 are formed of the same material, for example. In addition, the base portion 60 and the detachable portion 62 are formed of different materials, for example.

The outer region 52 includes a first member 56 and a second member 58. A part of the second member 58 is placed on the base portion 60. Another part of the second member 58 is placed on the detachable portion 62. The second member 58 has a ring shape.

Since the susceptor 14 according to the sixth embodiment has the detachable portion 62 that can be separated from the base portion 60, the maintenance thereof becomes easy.

As described above, according to the vapor phase growth apparatus according to the sixth embodiment, it is possible to improve the uniformity of the temperature of the substrate as in the first embodiment. Therefore, the uniformity of the properties of the film formed on the substrate is improved.


(Seventh Embodiment)

A vapor phase growth apparatus according to a seventh embodiment is different from that of the first embodiment in that the substrate has an orientation flat, the support portion has a linear portion along the orientation flat when the substrate is placed on the holder, and the inner peripheral edge of the outer region facing the linear portion has a linear shape. Hereinafter, the description of a part of the content overlapping the first embodiment will be omitted.

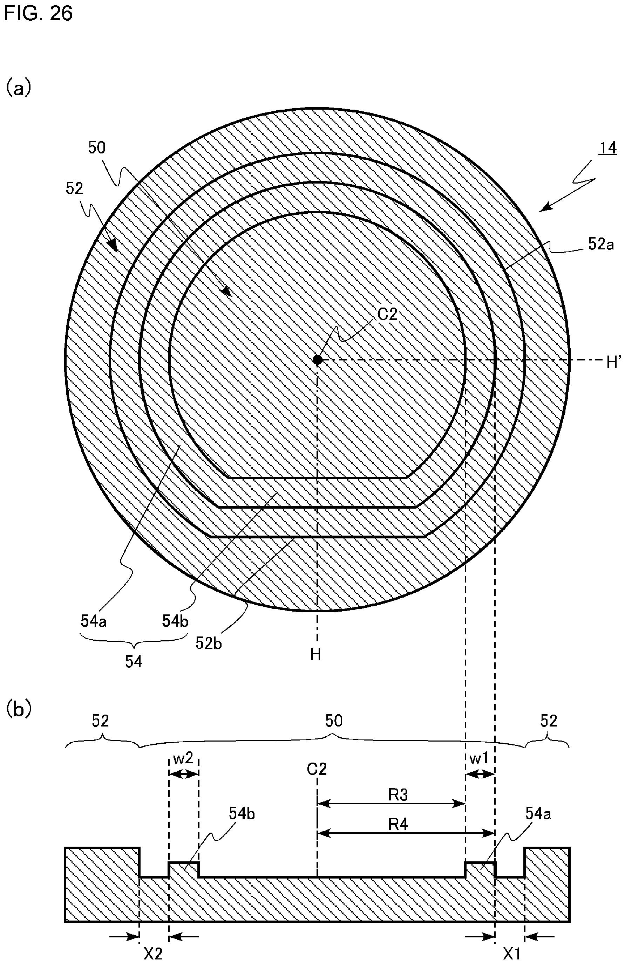

Fig. 26 is a schematic diagram of a holder according to the seventh embodiment. Fig. 26(a) is a top view, and Fig. 26(b) is a cross-sectional view taken along the line HH' of Fig. 26(a).

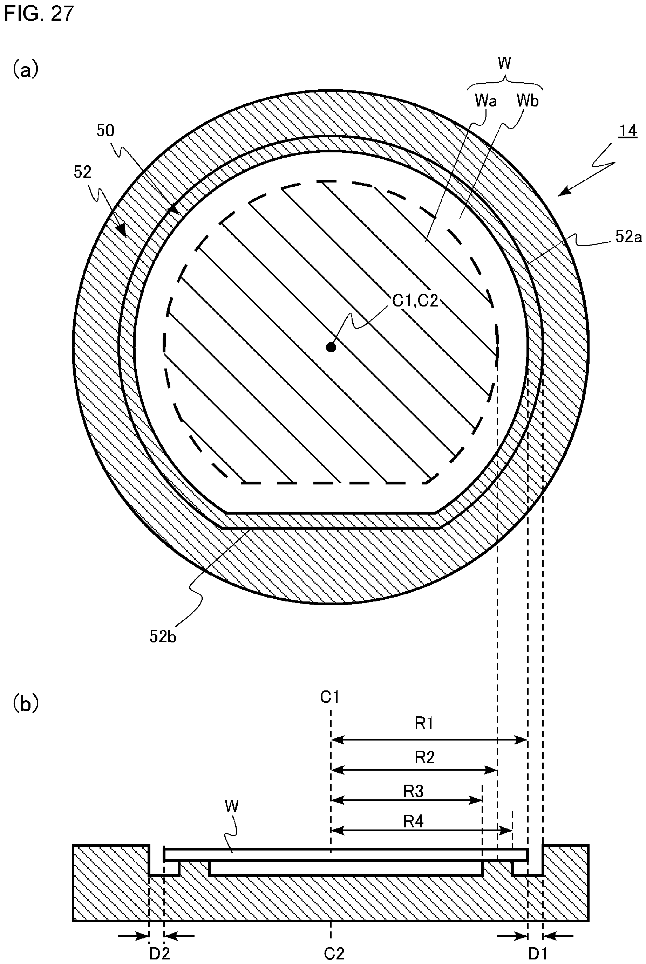

Fig. 27 is a schematic diagram of a holder according to the seventh embodiment. Fig. 27(a) is a top view corresponding to Fig. 26(a), and Fig. 27(b) is a cross-sectional view corresponding to Fig. 26(b).

Fig. 27 is a diagram showing a state in which the wafer W is placed on the susceptor 14. Fig. 27 shows a case where the center C1 of the wafer W and the center C2 of the susceptor 14 are aligned.

The wafer W has an orientation flat OF. The orientation flat OF is a linear portion provided on the outer periphery of the wafer W to indicate the crystal orientation of the wafer W.

The susceptor 14 includes an inner region 50 and an outer region 52. The outer region 52 surrounds the inner region 50. The outer region 52 surrounds a wafer W when the wafer W is placed on the susceptor 14.

The inner region 50 has a disc shape. The outer region 52 has an annular shape.

An annular support portion 54 is provided on the inner region 50. The annular support portion 54 includes an arc portion 54a and a linear portion 54b.

The support portion 54 can support the bottom surface of the wafer W when the wafer W is placed on the susceptor 14. The linear portion 54b extends along the orientation flat OF when the wafer W is placed on the susceptor 14. The linear portion 54b supports the bottom surface of the wafer W along the orientation flat OF.

A part 52b of the inner peripheral edge of the outer region 52 facing the linear portion 54b of the support portion 54 has a linear shape. The part 52b of the inner peripheral edge of the outer region 52 extends along the orientation flat OF when the wafer W is placed on the susceptor 14.

The width (wl in Fig. 26(a)) of the arc portion 54a of the support portion 54 and the width (w2 in Fig. 26(a)) of the linear portion 54b of the support portion 54 are equal, for example.

The distance (X2 in Fig. 26(b)) between the linear portion 54b and the part 52b of the inner peripheral edge of the outer region 52 facing the linear portion 54b is equal to the distance (X1 in Fig. 26(b)) between the arc portion 54a and another part 52a of the inner peripheral edge of the outer region 52 facing the arc portion 54a, for example.

In addition, the distance (D1 in Fig. 27(b)) between the outer peripheral edge of the wafer W and another part 52a of the inner peripheral edge of the outer region 52 facing the arc portion 54a is equal to the distance (D2 in Fig. 27(b)) between the outer peripheral edge of the wafer W and the part 52b of the inner peripheral edge of the outer region 52 facing the linear portion 54b, for example.

According to the susceptor 14 according to the seventh embodiment, the uniformity of the temperature of the wafer W is maintained even when the wafer W has the orientation flat OF.

As described above, according to the vapor phase growth apparatus according to the seventh embodiment, it is possible to improve the uniformity of the temperature of the substrate as in the first embodiment. Therefore, the uniformity of the properties of the film formed on the substrate is improved.

(Eighth Embodiment)

A vapor phase growth apparatus according to an eighth embodiment is different from that of the seventh embodiment in that the distance between the outer peripheral edge of the linear portion and the inner peripheral edge of the outer region is larger than the distance between the outer peripheral edge of the arc portion and the inner peripheral edge of the outer region. Hereinafter, the description of a part of the content overlapping the first and seventh embodiments will be omitted.

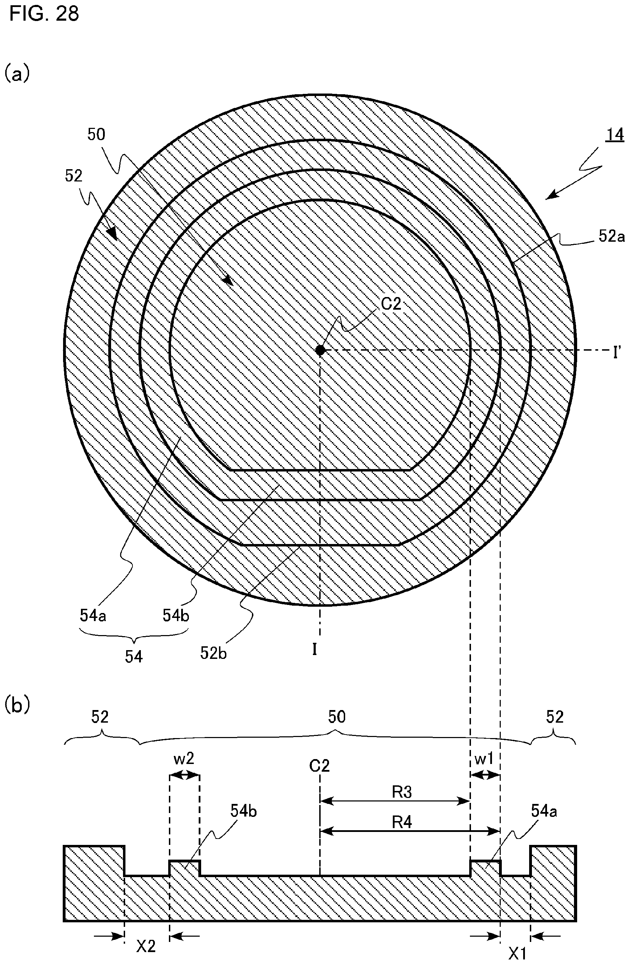

Fig. 28 is a schematic diagram of a holder according to the eighth embodiment. Fig. 28(a) is a top view, and Fig. 28(b) is a cross-sectional view taken along the line II' of Fig. 28(a).

The distance (X2 in Fig. 28(b)) between the linear portion 54b and the part 52b of the inner peripheral edge of the outer region 52 facing the linear portion 54b is larger than the distance (X1 in Fig. 28(b)) between the arc portion 54a and another part 52a of the inner peripheral edge of the outer region 52 facing the arc portion 54a, for example. The distance X2 is, for example, 1.2 to 3 times the distance X1. The distance between the outer peripheral edge of the support portion 54 and the inner peripheral edge of the outer region 52 in the linear portion 54b is larger than that in the arc portion 54a.

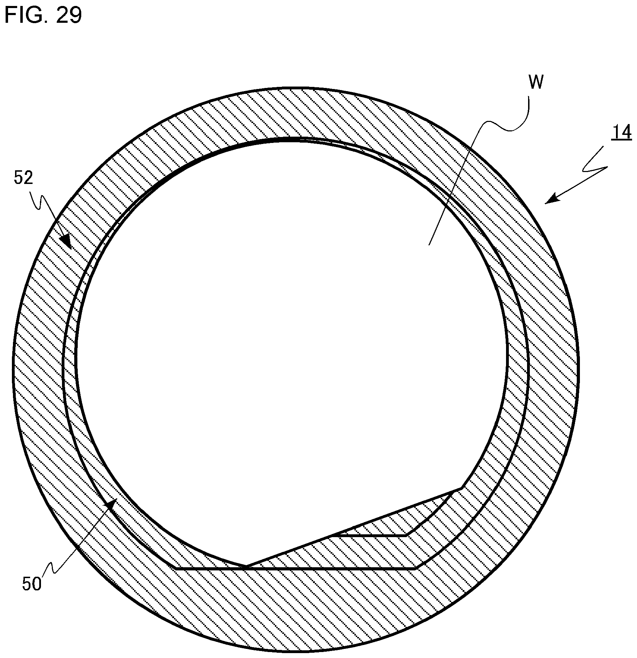

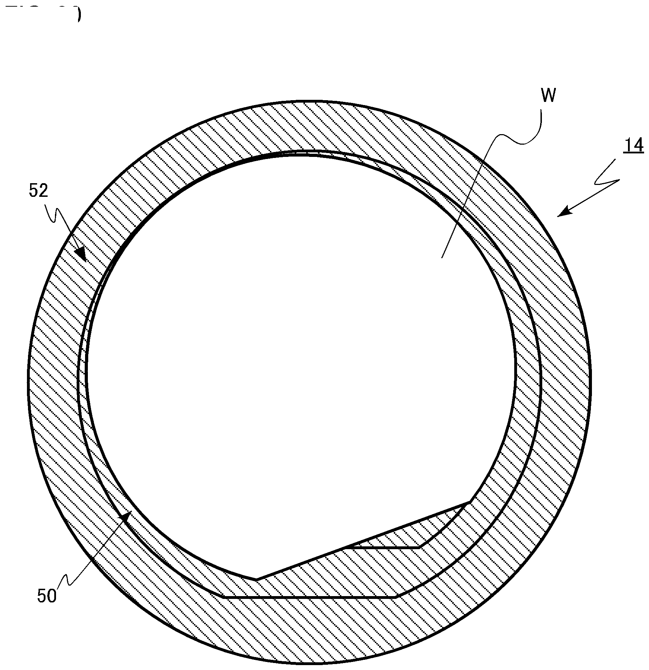

Fig. 29 is an explanatory diagram of the function and effect of the eighth embodiment. Fig. 29 is a schematic diagram of a holder according to the seventh embodiment. Fig. 29 is a top view.

In the susceptor 14 according to the seventh embodiment, unlike the susceptor 14 according to the eighth embodiment, the distance (X2 in Fig. 26(b)) between the linear portion 54b and the part 52b of the inner peripheral edge of the outer region 52 facing the linear portion 54b is equal to the distance (X1 in Fig. 26(b)) between the arc portion 54a and another part 52a of the inner peripheral edge of the outer region 52 facing the arc portion 54a.

As shown in Fig. 29, when the wafer W rotates relative to the susceptor 14, the wafer W may be interposed and fixed between the inner peripheral edges of the outer region 52. In such a case, for example, when the temperature of the reactor 10 drops after the film is formed on the wafer W, a compressive stress is applied to the wafer W due to the difference in thermal expansion coefficient between the wafer W and the outer region 52, which may cause the wafer W to crack.

Fig. 30 is an explanatory diagram of the function and effect of the eighth embodiment. Fig. 30 is a schematic diagram of a holder according to the eighth embodiment. Fig. 30 is a top view.

Fig. 30 shows a case where the wafer W placed on the susceptor 14 according to the eighth embodiment is rotated relative to the susceptor 14. In the susceptor 14 according to the eighth embodiment, the distance (X2 in Fig. 28(b)) between the linear portion 54b and the part 52b of the inner peripheral edge of the outer region 52 facing the linear portion 54b is larger than the distance (X1 in Fig. 28(b)) between the arc portion 54a and another part 52a of the inner peripheral edge of the outer region 52 facing the arc portion 54a. Therefore, the occurrence of a situation in which the wafer W is interposed and fixed between the inner peripheral edges of the outer region 52 is suppressed. As a result, the occurrence of a situation in which a compressive stress is applied to the wafer W to cause the wafer W to crack is suppressed.

The distance X2 is preferably 1.2 to 2 times the distance X1. By setting the distance X2 to 1.2 times or more the distance X1, the occurrence of a situation in which the wafer W is interposed and fixed between the inner peripheral edges of the outer region 52 is suppressed. In addition, by setting the distance X2 to 2 times or less the distance X1, it is possible to suppress the occurrence of a situation in which the process gas flows into the back surface of the wafer W and a by-product adheres to the back surface of the wafer W.

As described above, according to the vapor phase growth apparatus according to the eighth embodiment, it is possible to improve the uniformity of the temperature of the substrate as in the first embodiment. Therefore, the uniformity of the properties of the film formed on the substrate is improved.

The embodiments of the invention have been described above with reference to specific examples. The above-described embodiments are merely given as examples, and do not limit the invention. In addition, the components of the respective embodiments may be combined as appropriate.

In the embodiments, the case of forming a single crystal silicon carbide film has been described as an example. However, the invention can also be applied to the formation of a polycrystalline or amorphous silicon carbide film. In addition, the invention can also be applied to the formation of a film other than the silicon carbide film having a high film formation temperature.

In addition, in the embodiments, the wafer of single crystal silicon carbide has been described as an example of the substrate. However, the substrate is not limited to the wafer of single crystal silicon carbide.

In the embodiments, the description of parts that are not directly required for the description of the invention, such as the apparatus configuration or the manufacturing method, is omitted. However, the required apparatus configuration, manufacturing method, and the like can be appropriately selected and used. In addition, all vapor phase growth apparatuses that include the elements of the invention and that can be appropriately redesigned by those skilled in the art are included in the scope of the invention. The scope of the invention is defined by the scope of claims and the scope of their equivalents.

EXPLANATIONS OF LETTERS OR NUMERALS

| | |
|---|---|
| 10 | REACTOR |
| 14 | SUSCEPTOR (HOLDER) |
| 22 | FIRST HEATER |
| 42 | SECOND HEATER |
| 50 | INNER REGION |
| 52 | OUTER REGION |
| 54 | SUPPORT PORTION |
| 54a | ARC PORTION |
| 54b | LINEAR PORTION |
| 56 | FIRST MEMBER |
| 58 | SECOND MEMBER |
| 100 | VAPOR PHASE GROWTH APPARATUS |
| OF | ORIENTATION FLAT |
| W | WAFER (SUBSTRATE) |
| Wa | FILM QUALITY GUARANTEED REGION |
| X | DISTANCE |
| w | WIDTH |

**Claims**

1. A vapor phase growth apparatus, comprising:

   a reactor;
   a holder provided in the reactor to place a substrate thereon;
   a first heater provided in the reactor and located below the holder; and
   a second heater provided in the reactor and located above the holder,
   wherein the holder includes an inner region, an annular outer region surrounding the inner region and surrounding the substrate when the substrate is placed, and a support portion provided on the inner region, capable of supporting a bottom surface of the substrate, having an annular shape, and having an arc portion,
   a distance between an outer peripheral edge of the arc portion and an inner peripheral edge of the outer region is equal to or less than 6 mm,
   a width of the support portion is equal to or more than 3 mm, and
   when the substrate is placed on the holder so that a center of the substrate and a center of the holder are aligned, assuming that a radius of the substrate is R1, a radius of the outer peripheral edge of the arc portion is R4, and a distance between an outer peripheral edge of the substrate and an inner peripheral edge of the outer region facing the arc portion is D1, following Expression 1 is satisfied,

$$R1 - D1 > R4...(\text{Expression 1}).$$

2. The vapor phase growth apparatus according to claim 1,
   wherein, assuming that a radius of a film quality guaranteed region of the substrate is R2 and a radius of an inner peripheral edge of the arc portion is R3, the holder satisfies following Expressions 2 and 3,

$$R2 - D1 > R3...(\text{Expression 2}),$$

$$R2 + D1 < R4...(\text{Expression 3}).$$

3. The vapor phase growth apparatus according to claim 1,

wherein the outer region includes a first member containing carbon and a second member provided on the first member, separable from the first member, and having at least a surface containing silicon carbide.

4. The vapor phase growth apparatus according to claim 3,
wherein a boundary between the first member and the second member is located below a top surface of the substrate placed on the holder.

5. The vapor phase growth apparatus according to claim 3,
wherein the second member is formed of silicon carbide.

6. The vapor phase growth apparatus according to claim 3,
wherein the first member has an outer periphery fixing portion protruding upward from an outer peripheral edge of the first member and surrounding the second member.

7. The vapor phase growth apparatus according to claim 6,
wherein the first member has an inner periphery fixing portion protruding upward from an inner peripheral edge of the first member and surrounded by the second member.

8. The vapor phase growth apparatus according to claim 1,
wherein the holder has a plurality of protrusions on an inner peripheral side of the outer region.

9. The vapor phase growth apparatus according to claim 1,

wherein the substrate has an orientation flat,
the support portion has a linear portion along the orientation flat when the substrate is placed on the holder, and
the inner peripheral edge of the outer region facing the linear portion has a linear shape.

10. The vapor phase growth apparatus according to claim 9,
wherein a distance between an outer peripheral edge of the linear portion and the inner peripheral edge of the outer region is larger than a distance between the outer peripheral edge of the arc portion and the inner peripheral edge of the outer region.

**Amended claims under Art. 19.1 PCT**

1. A vapor phase growth apparatus, comprising:

a reactor;
a holder provided in the reactor to place a substrate thereon;
a first heater provided in the reactor and located below the holder; and
a second heater provided in the reactor and located above the holder,
wherein the holder includes an inner region, an annular outer region surrounding the inner region and surrounding the substrate when the substrate is placed, and a support portion provided on the inner region, capable of supporting a bottom surface of the substrate, having an annular shape, and having an arc portion,
a distance between an outer peripheral edge of the arc portion and an inner peripheral edge of the outer region is equal to or less than 6 mm,
a width of the support portion is equal to or more than 3 mm, and
when the substrate is placed on the holder so that a center of the substrate and a center of the holder are aligned, assuming that a radius of the substrate is R1, a radius of a film quality guaranteed region of the substrate is R2, a radius of an inner peripheral edge of the arc portion is R3, a radius of the outer peripheral edge of the arc portion is R4, and a distance between an outer peripheral edge of the substrate and an inner peripheral edge of the outer region facing the arc portion is D1, following Expressions 1, 2, and 3 are satisfied,

$$R1 - D1 > R4 \cdots \text{(Expression 1)},$$

$$R2 - D1 > R3 \cdots \text{(Expression 2)},$$

$$R2 + D1 < R4 \cdots \text{(Expression 3)}.$$

2. The vapor phase growth apparatus according to claim 1,
   wherein the outer region includes a first member containing carbon and a second member provided on the first member, separable from the first member, and having at least a surface containing silicon carbide.

3. The vapor phase growth apparatus according to claim 2,
   wherein a boundary between the first member and the second member is located below a top surface of the substrate placed on the holder.

4. The vapor phase growth apparatus according to claim 2,
   wherein the second member is formed of silicon carbide.

5. The vapor phase growth apparatus according to claim 2,
   wherein the first member has an outer periphery fixing portion protruding upward from an outer peripheral edge of the first member and surrounding the second member.

6. The vapor phase growth apparatus according to claim 5,
   wherein the first member has an inner periphery fixing portion protruding upward from an inner peripheral edge of the first member and surrounded by the second member.

7. The vapor phase growth apparatus according to claim 1,
   wherein the holder has a plurality of protrusions on an inner peripheral side of the outer region.

8. The vapor phase growth apparatus according to claim 1,

   wherein the substrate has an orientation flat,
   the support portion has a linear portion along the orientation flat when the substrate is placed on the holder, and
   the inner peripheral edge of the outer region facing the linear portion has a linear shape.

9. The vapor phase growth apparatus according to claim 8,
   wherein a distance between an outer peripheral edge of the linear portion and the inner peripheral edge of the outer region is larger than a distance between the outer peripheral edge of the arc portion and the inner peripheral edge of the outer region.

FIG. 1

FIG. 2

(a)

(b)

FIG. 3

(a)

(b)

FIG. 4

(a)

(b)

FIG. 5

(a)

(b)

FIG. 6

(a)

(b)

FIG. 7

(a)

(b)

FIG. 8

(a)

(b)

FIG. 9

(a)

(b)

FIG. 10

(a)

(b)

FIG. 11

(a)

(b)

FIG. 12

(a)

(b)

FIG. 13

(a)

(b)

FIG. 14

(a)

50             52

D1

Ex    54    W            E3

E1      E2

(b)

50             52

D1

54    Ex      W    E3

E1      E2

FIG. 15

(a)

(b)

FIG. 16

(a)

(b)

FIG. 17

(a)

(b)

FIG. 18

(a)

(b)

FIG. 19

(a)

(b)

FIG. 20

(a)

(b)

FIG. 21

(a)

(b)

FIG. 22

(a)

(b)

FIG. 23

(a)

(b)

FIG. 24

(a)

(b)

FIG. 25

(a)

(b)

FIG. 26

(a)

(b)

FIG. 27

(a)

(b)

FIG. 28

(a)

(b)

FIG. 29

FIG. 29

**INTERNATIONAL SEARCH REPORT**

| International application No. |
|---|
| **PCT/JP2021/038355** |

| | |
|---|---|
| **A.** | **CLASSIFICATION OF SUBJECT MATTER** |

*H01L 21/205*(2006.01)i; *C23C 16/458*(2006.01)i; *C23C 16/46*(2006.01)i
FI:  H01L21/205; C23C16/46; C23C16/458

According to International Patent Classification (IPC) or to both national classification and IPC

| | |
|---|---|
| **B.** | **FIELDS SEARCHED** |

Minimum documentation searched (classification system followed by classification symbols)

H01L21/205; C23C16/458; C23C16/46

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| Y | JP 2018-037537 A (NUFLARE TECHNOLOGY INC.) 08 March 2018 (2018-03-08) paragraphs [0066]-[0072], [0094]-[0104], fig. 1, 5, 6, 10-12 | 1, 8-10 |
| A | | 2-7 |
| Y | WO 2019/044440 A1 (NUFLARE TECHNOLOGY INC.) 07 March 2019 (2019-03-07) paragraphs [0024]-[0026], [0043], fig. 1 | 1, 8-10 |
| A | | 2-7 |
| Y | WO 2009/060912 A1 (SUMCO CORP.) 14 May 2009 (2009-05-14) paragraphs [0052]-[0055], fig. 11, 12 | 1, 8-10 |
| A | | 2-7 |
| Y | JP 2018-082100 A (SHOWA DENKO KK) 24 May 2018 (2018-05-24) paragraphs [0062], fig. 8 | 9-10 |
| A | | 1-8 |

| | |
|---|---|
| ✓ Further documents are listed in the continuation of Box C. | ✓ See patent family annex. |

| | |
|---|---|
| *   Special categories of cited documents: | "T"  later document published after the international filing date or priority date and not in conflict with the application but cited to understand the principle or theory underlying the invention |
| "A"  document defining the general state of the art which is not considered to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | "&"  document member of the same patent family |
| "P"  document published prior to the international filing date but later than the priority date claimed | |

| Date of the actual completion of the international search | Date of mailing of the international search report |
|---|---|
| **22 November 2021** | **07 December 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT

International application No.

**PCT/JP2021/038355**

**C. DOCUMENTS CONSIDERED TO BE RELEVANT**

| Category* | Citation of document, with indication, where appropriate, of the relevant passages | Relevant to claim No. |
|---|---|---|
| Y | JP 09-063966 A (TOSHIBA MICROELECTRONICS CORP.) 07 March 1997 (1997-03-07) paragraph [0006], fig. 3 | 9-10 |
| A | | 1-8 |
| A | JP 2018-073886 A (NUFLARE TECHNOLOGY INC.) 10 May 2018 (2018-05-10) | 1-10 |
| A | US 2002/0083896 A1 (YOUNG, Ho Bae) 04 July 2002 (2002-07-04) | 1-10 |

Form PCT/ISA/210 (second sheet) (January 2015)

**INTERNATIONAL SEARCH REPORT**
Information on patent family members

International application No.

**PCT/JP2021/038355**

| Patent document cited in search report | | | Publication date (day/month/year) | Patent family member(s) | | | Publication date (day/month/year) |
|---|---|---|---|---|---|---|---|
| JP | 2018-037537 | A | 08 March 2018 | US | 2018/0057958 | A1 | |
| | | | | paragraphs [0072]-[0078], [0100]-[0110], fig. 1, 5, 6, 10-12 | | | |
| WO | 2019/044440 | A1 | 07 March 2019 | US | 2020/0190692 | A1 | |
| | | | | paragraphs [0030]-[0032], [0049], fig. 1 | | | |
| | | | | EP | 3678164 | A1 | |
| | | | | KR | 10-2020-0036898 | A | |
| | | | | CN | 111052308 | A | |
| | | | | TW | 201920762 | A | |
| WO | 2009/060912 | A1 | 14 May 2009 | US | 2010/0227455 | A1 | |
| | | | | paragraphs [0077]-[0080], fig. 11, 12 | | | |
| | | | | TW | 200935500 | A | |
| JP | 2018-082100 | A | 24 May 2018 | (Family: none) | | | |
| JP | 09-063966 | A | 07 March 1997 | (Family: none) | | | |
| JP | 2018-073886 | A | 10 May 2018 | US | 2018/0114715 | A1 | |
| | | | | CN | 107978552 | A | |
| | | | | KR | 10-2018-0045807 | A | |
| | | | | TW | 201820418 | A | |
| US | 2002/0083896 | A1 | 04 July 2002 | KR | 10-2002-0055291 | A | |

Form PCT/ISA/210 (patent family annex) (January 2015)

**EP 4 243 054 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018037537 A